**Europäisches Patentamt**

**European Patent Office**

**Office européen des brevets**

(19)

(11) Publication number: **0 111 661**
**A2**

(12)
# EUROPEAN PATENT APPLICATION

(21) Application number: **83110142.3**

(22) Date of filing: **13.03.80**

(51) Int. Cl.³: **G 03 B 41/00**

(30) Priority: **03.04.79 US 26722**
**02.07.79 US 53995**

(43) Date of publication of application:
**27.06.84 Bulletin 84/26**

(84) Designated Contracting States:
**DE FR GB IT**

(60) Publication number of the earlier application
in accordance with Art. 76 EPC: **0 017 759**

(71) Applicant: **Optimetrix Corporation**
**500 Ellis Street**
**Mountain View California 94043(US)**

(72) Inventor: **Phillips, Edward H.**
**500 Ellis Street**
**Mountain View, CA. 94043(US)**

(72) Inventor: **Johannsmeier, Karl-Heinz**
**400 Fir Lane**
**Los Altos, CA 94022(US)**

(74) Representative: **Liesegang, Roland, Dr.-Ing.**
**Sckellstrasse 1**
**D-8000 München 80(DE)**

(54) Photometric printing apparatus.

(57) A photometric printing apparatus including a holder (16) for holding a first object (12) in a first plane; a stage (20) for holding a second object (14) in a second plane (77); a light source unit (24), optically disposed on one side of the holder (16), for illuminating the first object (12); a projection lens (18), optically disposed on the other side of the holder (16) and between the holder (16) and the stage (20), for projecting an image of illuminated portions of the first object (12) onto the second object (14); and control means (25,27), coupled to the stage (20), for moving the stage (20) to facilitate printing of an image of an illuminated portion (160) of the first object (12) at different regions (162) of the second object (14) comprises additionally adjustable mounting means by an indicium disposed on the stage (20) for being positioned in the second plane (77) to facilitate alignment of the image of the first object (12) with respect to one of the axes (X,Y) of motion of the stage (20).

EP 0 111 661 A2

./...

FIGURE 1A

PHOTOMETRIC PRINTING APPARATUS  0111661

### Background and Summary of the Invention

This invention relates generally to step-and-repeat alignment and exposure systems utilizing a projection lens of the reduction type for the photometric printing of an image of a first object, such as a reticle, upon a second object, such as photomask or a semiconductive wafer, and, more specifically, to apparatus for use in such systems to achieve precise relative alignments of a reticle and a semi-conductive wafer with respect to coordinate axes of motion of a movable stage for holding the semiconductive wafer.

This invention further relates to alignment systems for achieving precise relative alignments of a first object, such as a photomask or a reticle, and a second object, such as a semiconductive wafer or a photomask, and, more particularly, to apparatus for use in such systems to facilitate precise positioning of the first object with respect to an axis of motion of a movable stage for holding the second object.

In the semiconductor industry projection lenses of the reduction type are employed both in the fabrication of photomasks and in the processing of semiconductive wafers to form integrated circuits and the like. A high (submicron) resolution photomask is typically fabricated by utilizing a precisely controlled stage to successively position adjacent regions of the photomask with respect to an image (formed by such a projection lens) of a reticle containing a level of microcircuitry that is printed on the photomask at each of those regions. This step-and-repeat printing operation forms an array of adjacent regions of microcircuitry of one level on the photomask in rows and columns parallel to the coordinate axes of motion of the stage. A set of such photomasks, each bearing an array of microcircuitry of a different level, is typically employed in the fabrication of integrated circuits or the like from a semiconductive wafer. In the course of this fabrication, the semiconductive wafer is sequentially

-!-

aligned with each photomask of the set and the level of microcircuitry printed on the photomask is in turn printed on the semiconductive wafer. However, it is also possible to eliminate the operation of fabricating a set of such photomasks by employing a precisely controlled stage to successively position adjacent regions of the semiconductive wafer with respect to each of the reticles employed in fabricating the set of photomasks so that the level of microcircuitry contained on each of those reticles may be printed directly on the semiconductive wafer at each of those regions during separate step-and-repeat printing operations.

In order to facilitate the precise positioning or alignment of one level of microcircuitry being printed on a semiconductive wafer at each of an array of adjacent regions thereof relative to another level of microcircuitry previously printed or yet to be printed on the semiconductive wafer at each of those same regions, it would be highly desirable to employ a step-and-repeat alignment and exposure system utilizing a projection lens of the reduction type in the optical portion thereof while allowing direct viewing and alignment of the reticle, or an image of the reticle, with respect to the coordinate axes of motion of the stage, and further allowing direct viewing and alignment of microcircuitry previously printed on the semiconductive wafer at each of those regions with respect to the reticle, or image of the reticle. Unfortunately, however, conventional step-and-repeat alignment and exposure systems utilizing projection lenses of the reduction type do not allow such direct viewing and alignment of either the reticle, or an image of the reticle, or the semiconductive wafer.

In order, for example, to facilitate the precise positioning or alignment of one level of microcircuitry being printed on a semiconductive wafer at each of an array of adjacent regions thereof relative to another level of microcircuitry previously printed or yet to be printed on the semiconductive wafer at each of those same regions, it would be highly desireable to employ a precisely controlled stage having a visible indicuim of at least one of the coordinate axes of motion of the stage so as to facilitate the precise and repeatable positioning of a photomask or a reticle with respect to that axis of motion of the stage. Unfortunately, however, the stages employed in conventional step-and-repeat alignment and exposure systems do not have such an indicium.

Accordingly, it is ~~the principal~~ an object of this invention to provide an improved alignment system with a precisely controlled movable stage having a visible reference mark that is indicative of at least one of coordinate axes of motion of the stage.

Another object of this invention is to provide an improved step-and-repeat alignment and exposure system incorporating a projection lens of the reduction
type in the optical portion thereof while allowing direct
viewing and alignment of an image of a first object, such as
a reticle, and of a second object, such as a semiconductive
wafer.

Another object of this invention is to provide the
optical portion of the step-and-repeat alignment and exposure
system with a viewing port for observing the image plane of
the projection lens.

Another object of this invention is to provide the
optical portion of the step-and-repeat alignment and exposure
system with masking apparatus for selectively illuminating
different portions of the reticle.

Another object of this invention is to provide the step-
and-repeat alignment and exposure system with a controlled
movable stage having a visible reference mark that is indicative of at least one of coordinate axes of motion of the
stage.

Another object of this invention is to provide the
step-and-repeat alignment and exposure system with a reticle
alignment subsystem for precisely and repeatably aligning
an image of each reticle of a set of different reticles with
respect to the axes of motion of the controlled movable stage.

Another object of this invention is to provide the
step-and-repeat alignment and exposure system with a wafer
alignment subsystem for precisely aligning a previously-
printed array of adjacent regions of microcircuitry on the
semiconductive wafer with respect to the axes of motion of the controlled movable stage.

Still another object of this invention is to provide the step-and-repeat alignment and exposure system with a wafer alignment subsystem for directly aligning the previously-printed regions of microcircuitry on the semiconductive wafer with respect to an image of each reticle of a set of different reticles.

These and other objects, which will become apparant from an inspection of the accompanying drawings and a reading of the associated description, are accomplished according to the illustrated preferred embodiment of this invention by providing a step-and-repeat alignment and exposure system including a main stage controlled for movement to different positions along orthogonal X and Y axes; a chuck mounted on the main stage for supporting a semiconductive wafer thereon; a substage mounted on the main stage for aligning a reference mark on the substage with one of the X and Y axes of motion of the main stage; another stage controlled for aligning a reticle supported thereon with the reference mark; a projection lens of the reduction type mounted between the main stage and the other stage for imaging illuminated portions of the reticle onto portions of the reference mark or the semiconductive wafer, depending on the position to which the main stage is moved; a light source for directing illumination and exposure light along an optical path extending through the reticle; a pair of filters and a compensating lens mounted for selectively controlling the type of light (i.e., whether illumination light or exposure light passing along that optical path to the reticle and for accommodating the projection lens for the type of light selected; a pair of

-4-

shutters mounted for selectively controlling the passage of light along that optical path to the reticle; a plurality of different mask plates mounted for selectively controlling the portions of the reticle illuminated by the light passing along that optical path when one of the shutters is opened; and a beam splitter mounted between the projection lens and the reticle for providing a viewing port at which an aerial image of the portions of the reference mark or semiconductive wafer illuminated by the projected image of the illuminated portions of the reticle may be viewed.

The step-and-repeat alignment and exposure system also includes a first objective lens unit that may be moved into an operative position for use with an ocular lens unit to permit viewing of the aerial image provided at the viewing port while controlling the main stage to directly align either the reticle with the reference mark or the semiconductive wafer with the reticle; a pair of prealignment reticles mounted above the main stage and aligned with respect to the reference mark to permit prealignment of the semiconductive wafer with respect to the reference mark (and, hence, the reticle); and a second objective lens unit for imaging this pair of prealignment reticles onto a corresponding pair of alignment marks on the semiconductive wafer when the main stage is moved to position the semiconductive wafer directly beneath the second objective lens unit and for providing aerial images of the pair of alignment marks on the semiconductive wafer illuminated by the projected images of the pair of prealignment reticles. This second objective lens unit may be moved into the operative position (in lieu of the first objective lens unit) for use with the ocular lens unit to permit viewing of these aerial images while controlling the main stage to align the pair of alignment marks on the semiconductive wafer with the corresponding pair of prealignment reticles. Once the semiconductive wafer has been so aligned, the main stage may be controlled to step an array of adjacent regions of the semiconductive wafer directly beneath the projection lens to permit direct alignment of selected ones of those regions with the reticle while employing the first objective lens unit with the ocular lens unit for viewing an aerial image of an auxiliary alignment mark previously printed along side each selected region and illuminated by a corresponding alignment mark on the reticle and to further permit printing of a level of microcircuitry contained on the reticle at each of the array of adjacent regions.

## Description of the Drawings

Figures 1A-C are perspective views of different portions of a step-and-repeat alignment and exposure system in accordance with the preferred embodiment of the present invention.

Figure 2 is a half-sectional, partially out-away elevational view of a portion of the step-and-repeat alignment and exposure system of Figures 1A-C.

Figure 3A is a plan view of a reference mark plate employed in the step-and-repeat alignment and exposure system of Figures 1A-C.

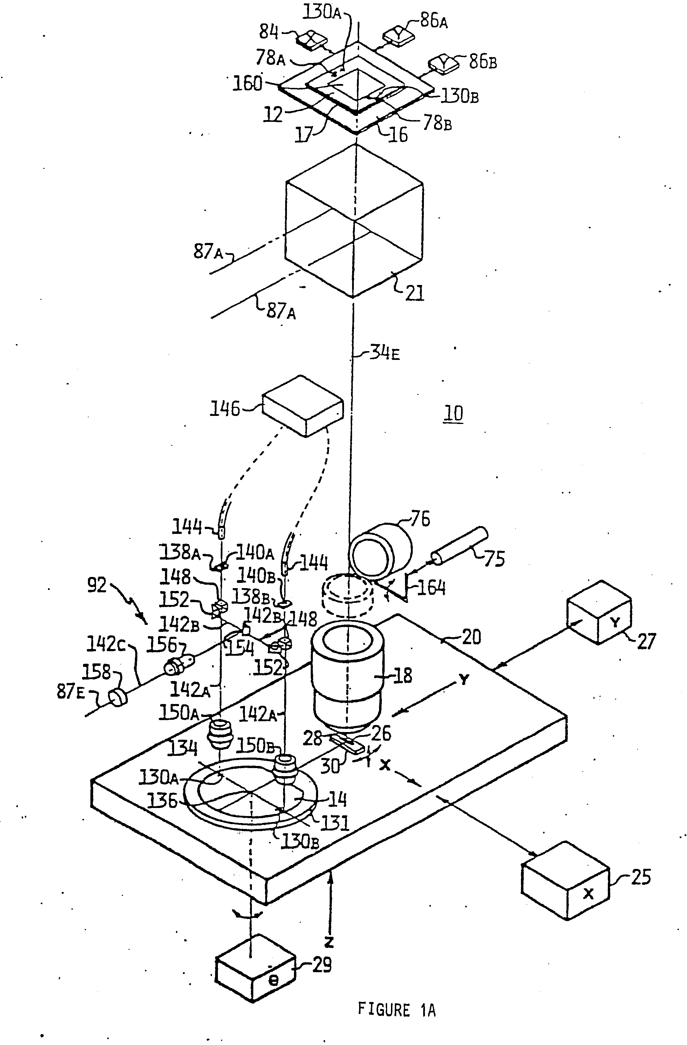

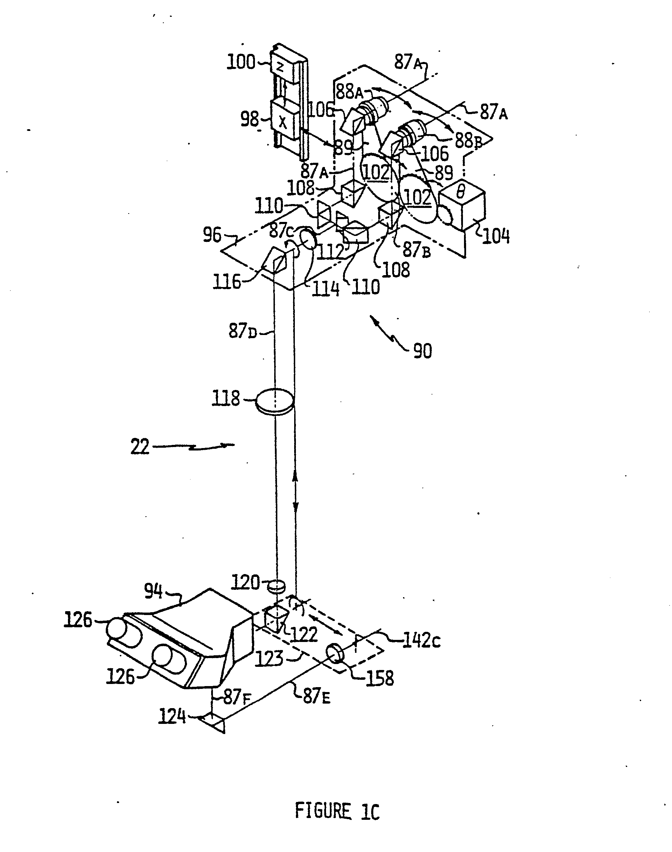

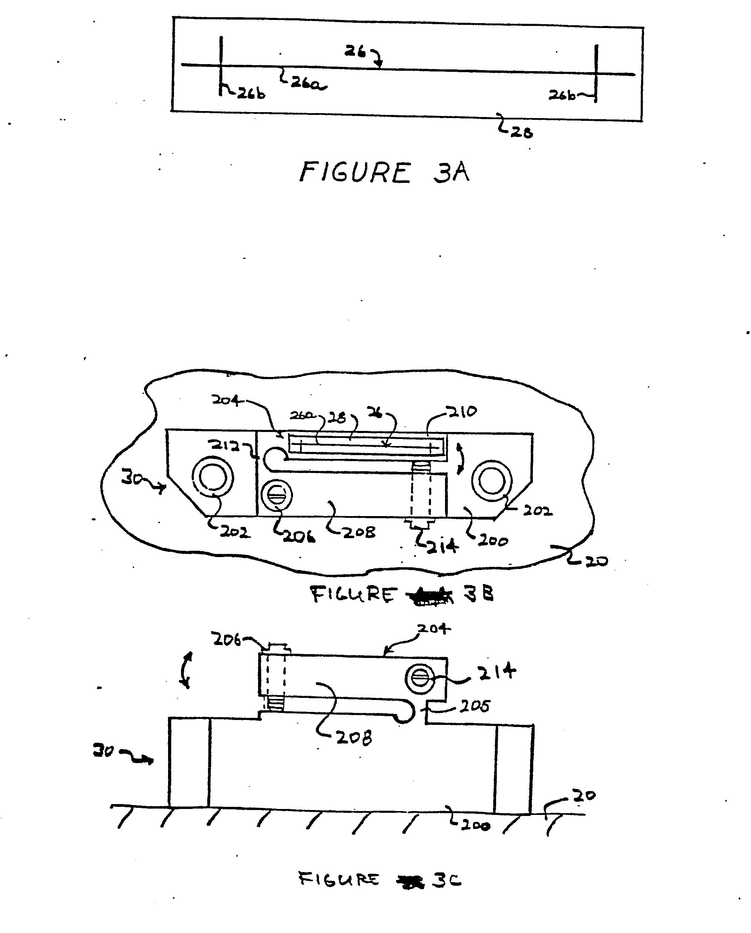

Figures 3A and 3B are top plan and side elevational views, respectively, of a substage employed in the step-and-repeat alignment and exposure system of Figures 1A-C to support the reference mark plate of Figure 3A.

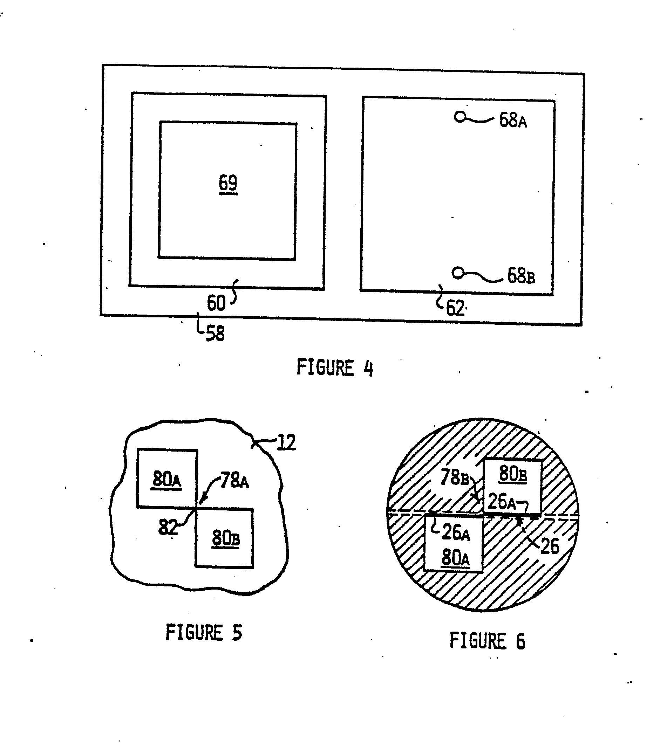

Figure 4 is a plan view of a slide holding two different masks employed in the step-and-repeat alignment and exposure system of Figures 1A-C.

Figure 5 is a plan view of one of a pair of reticle alignment marks contained on each reticle employed with the step-and-repeat alignment and exposure system of Figures 1A-C.

Figure 6 is a plan view of a portion of a reference mark formed on the reference mark plate of Figure 3 and illuminated by reticle alignment marks.

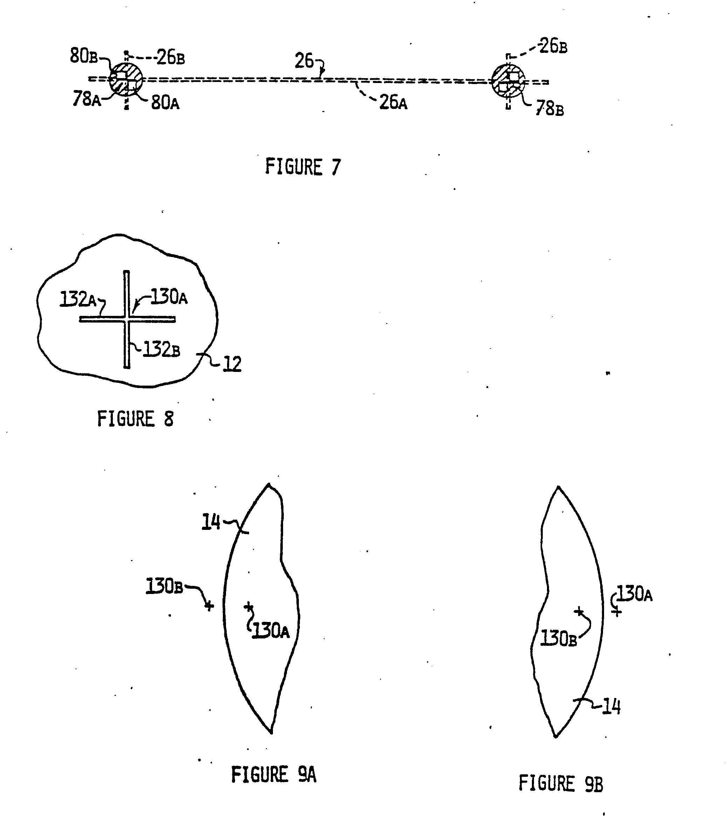

Figure 7 is a plan view of the end portions of the reference mark formed on the reference mark plate of Figure 3 and illuminated by projected images of a pair of reticle alignment marks.

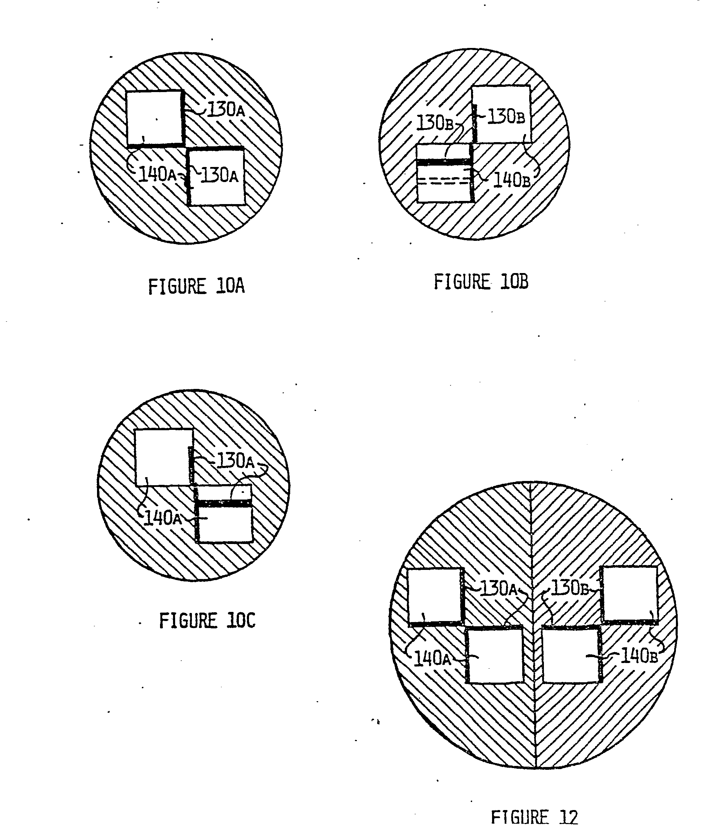

Figure 8 is a plan view of one of a pair of wafer alignment marks contained on a first reticle of a set of reticles employed with the step-and-repeat alignment and exposure system of Figures 1A-C.

Figure 9A-B are plan views illustrating how a pair of wafer alignment marks is printed on a semiconductive wafer by the step-and-repeat alignment and exposure system of Figures 1A-C.

Figure 10 A-C are plan views illustrating how the pair of wafer alignment marks printed on the semiconductive wafer may be employed in aligning a pair of prealignment reticles of the step-and-repeat alignment and exposure system with the reference mark.

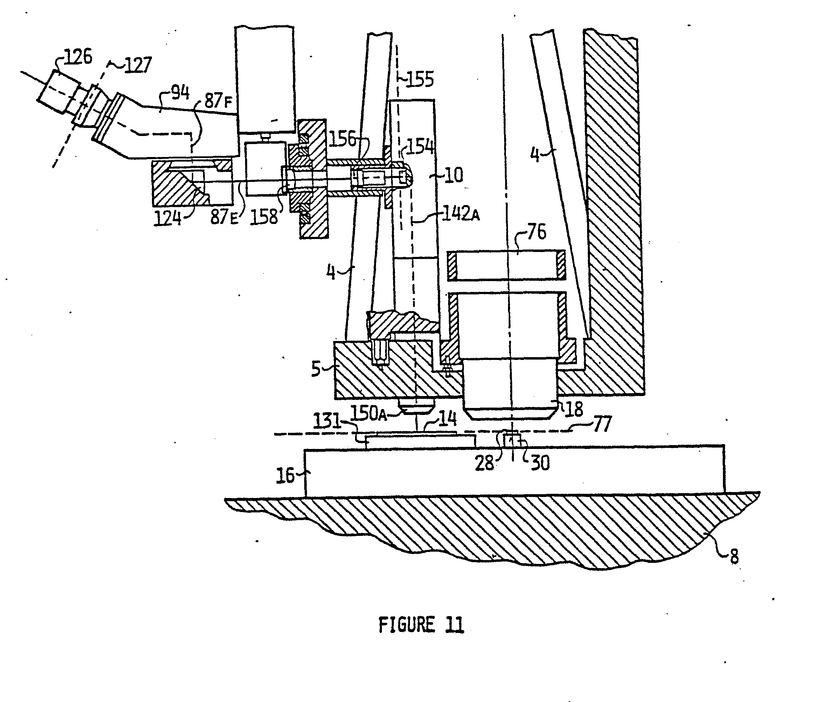

Figure 11 is a half-sectional elevational view of a portion of the step-and-repeat alignment and exposure system of Figures 1A-C.

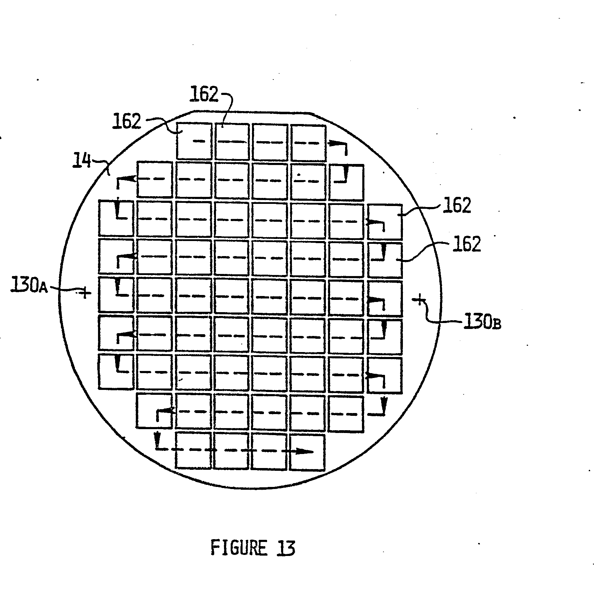

Figure 12 is a plan view of the pair of wafer alignment marks printed on the semiconductive wafer when they are precision prealigned with the pair of prealignment reticles.

Figure 13 is a plan view of the semiconductive wafer illustrating the manner in which a step-and-repeat printing operation is performed by the step-and-repeat alignment and exposure system of Figures 1A-C.

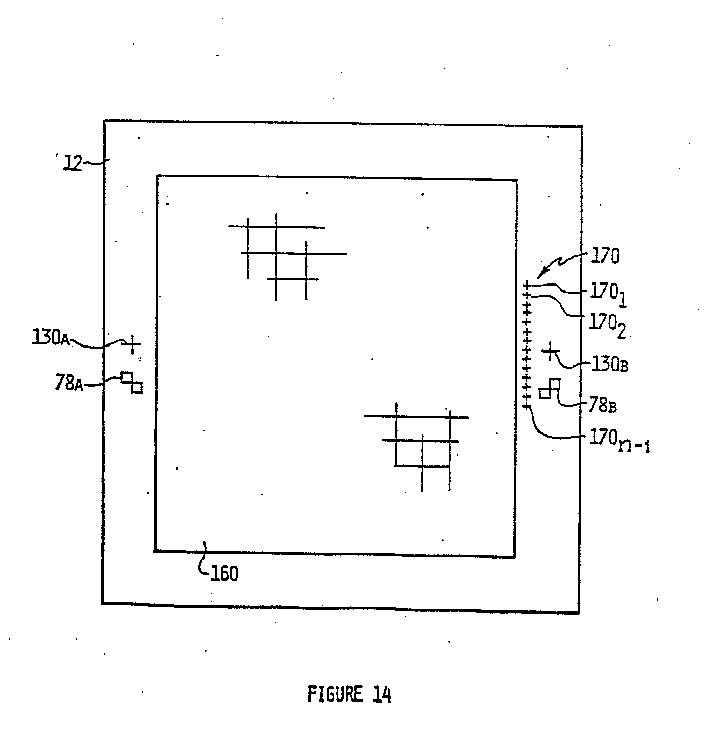

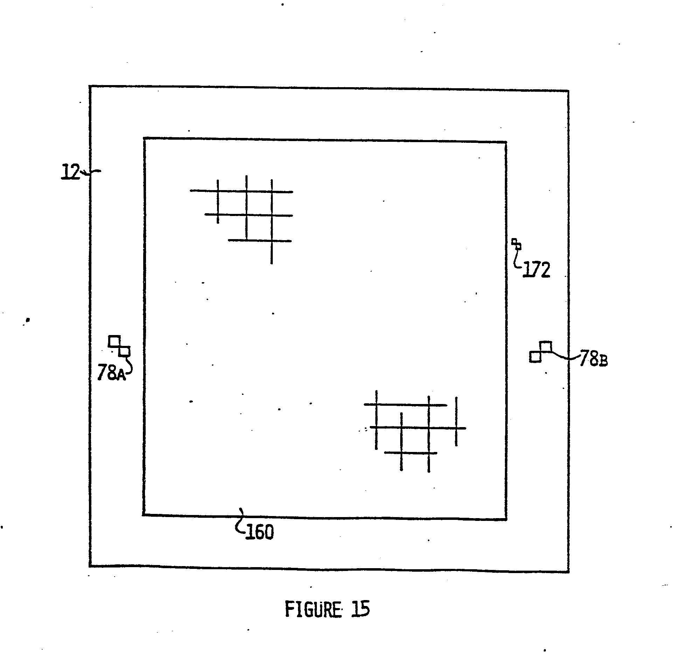

Figures 14 and 15 are plan views of portions of first and second reticles of a set of reticles employed with the step-and repeat alignment and exposure system of Figures 1A-C.

Description of the Preferred Embodiment

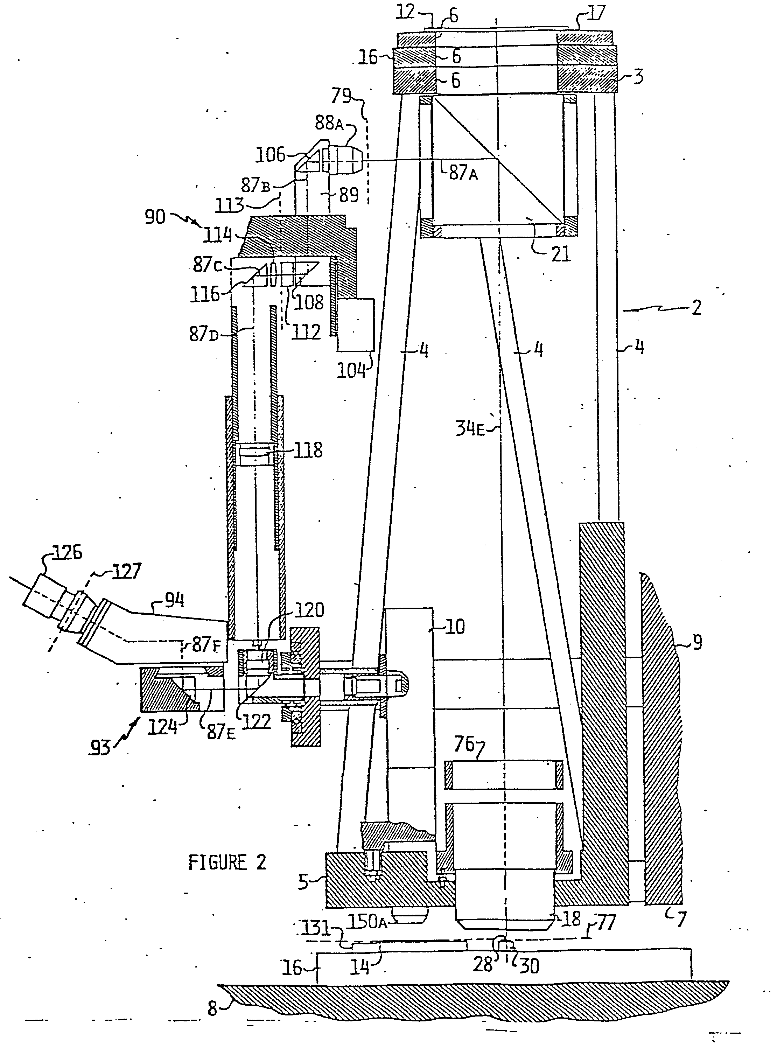

Referring now to Figures 1A-C and 2, there is shown a precision step-and-repeat alignment and exposure system 10 for repeatedly printing one level of microcircuitry, contained on a first object, such as a reticle 12, at an array of adjacent regions of a second object, such as a semiconductive wafer 14, in alignment with other levels of microcircuitry previously printed or yet to be printed at those same regions. Alignment and exposure system 10 includes a stage 16 for holding the reticle 12, a 10:1 projection lens 18 for projecting an image of illuminated portions of the reticle onto a reference mark 26 or the semiconductive wafer 14, a main stage 20 for positioning the reference mark or the semiconductive wafer with respect to the projected image of the illuminated portions of the reticle, a beam splitter 21 and a compound microscope 22 for viewing aerial images of portions of the reference mark or semiconductive wafer illuminated by the projected image of the reticle, and a light source unit 24 for selectively illuminating different portions of the reticle (with either illumination or exposure light) for viewing those aerial images during alignment operations and for selectively exposing a photosensitive film on the semiconductive wafer during step-and-repeat printing operations.

With reference now particularly to Figure 1A, main stage 20 may comprise an interferometrically-controlled stage of the type shown and described in detail in copending U.S. Patent Application Serial No. 015,713 entitled INTERFEROMETRICALLY CONTROLLED STAGE WITH PRECISELY ORTHOGONAL AXES OF MOTION, filed on February 27, 1979, by Edward H. Phillips, and incorporated by reference herein. As fully described in

that application, main stage 20 may be moved along orthogonal X and Y axes to any position in a horizontal plane by X and Y axes servo drive units 25 and 27. Either axis of motion of main stage 20 may therefore be employed as an absolute frame of reference, and the X axis is so employed, for alignment and exposure system 10, as hereinafter explained.

Reference mark 26 may be formed of bright chrome on a reference mark plate 28 fixedly mounted on a substage 30, which is in turn adjustably mounted on main stage 20. As best shown in Figure 3A, reference mark 26 may comprise a straight line 26a of about 12.7 millimeters in length and about 4 microns in width, and a pair of identical tic marks 26b of about 0.4 millimeters in length and about 4 microns in width. These tic marks 26b symmetrically and orthogonally intersect line 26a near the opposite ends thereof and are spaced 10.3 millimeters apart (center-to-center).

As best shown in Figures 3B and 3C, substage 30 may comprise a lower base member 200 fixedly secured to main stage 20 by screws or rivets 202, and an adjustable upper support member 204 secured to the lower base member, for example, by a solid hinge 205 permitting pivotal adjustment of the upper support member with respect to the plane of main stage 20 under control of an adjustment screw 206. This adjustment screw is screwed through a threaded screw hole in a first side portion 208 of upper support member 204 and into abutment with the upper surface of lower base member 200 so as to permit positioning of the upper surface of the upper support member and, hence, of reference mark plate 28 in a plane parallel to a first image plane 77 (see Figure 2) of projection lens 18 as desired for proper focusing of reference mark 26. A second smaller side portion 210 of upper support member 204 is secured to the first side portion 208, for example, by another solid hinge 212 permitting angular adjustment of the upper surface of the second side portion of the upper support member (and, hence, of reference mark plate 28, which is fixedly secured to that surface by an adhesive) in a plane parallel to the upper surface of main stage 20 under control of an adjustment screw 214. This adjustment screw is screwed through a threaded screw hole in the first side portion 208 of the upper support member 204 and into abutment with the smaller second side portion 210 of the upper support member so as to permit precise alignment of line 26a of reference mark 26 with the X axis of motion of the main stage as desired to provide a visual indication of the X axis of motion and thereby facilitate use of the X axis of motion as an absolute frame of reference for alignment and exposure system 10. In initially setting up alignment and exposure system 10, substage 30 is manually adjusted (by adjustment screws 206 and 214 to achieve the desired parallel-plane positioning of reference

-9A-

mark plate 28 and the desired alignment of line 26a of reference mark 26. Although this substage adjustment operation should only have to be performed once during the life of alignment and exposure system 10, it may be advisable to check the parallel-plane positioning of reference mark plate 28 and the alignment of line 26a of reference mark 26 from time to time. The manner in which the substage adjustment operation is performed will now be described with reference to the parts of alignment and exposure system 10 employed in that operation.

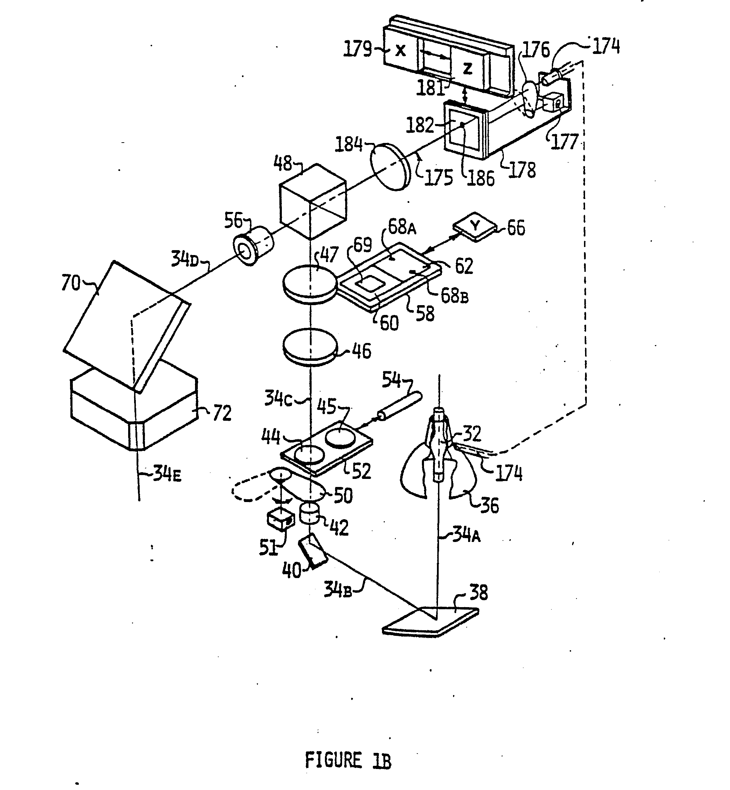

With reference now particularly to Figure 1B, light source unit 24 includes a mercury arc lamp 32 for emitting a spectrum of light energy including both green illuminating light have a wave length of about 547 nanometers for illuminating but not exposing the photosensitive film on semiconductive wafer 12, and blue illuminating and exposure light having a wavelength of about 436 nanometers for both illuminating and exposing the photosensitive film on the semiconductive wafer (herein simply referred to as exposure light). Mercury arc lamp 32 is fixedly mounted along a vertically extending portion 34a of an optical path 34a-e of alignment and exposure system 10. An elliptical reflector 36 surrounds mercury arc lamp 32 and is fixedly coaxially mounted therewith for projecting a beam of light emitted by the mercury arc lamp downward to a band reflecting plane mirror 38. This band reflecting plane mirror 38 has a multilayer dielectric coating for reflecting blue and green light, but transmitting all other light, in the beam of light to prevent unnecessary energy from being transmitted along the remaining portions of optical path 34a-e. Band reflecting plane mirror 38 is fixedly mounted in optical path 34a-e at an angle of forty-five degrees with respect to the vertically extending portion 34a thereof so as to deflect the blue and green light in the beam of light along a horizontally extending portion 34b of that optical path to a plane mirror 40.

Plane mirror 40 is fixedly mounted in optical path 34a-e at an angle of forty-five degrees with respect to the horizontally extending portion 34b thereof so as to deflect the beam of blue and green light incident thereon upward along another vertically extending portion 34c of that optical path. The beam of light so deflected thereupon passes through a light integrator 42 and, when a normally closed shutter 50 is opened as during the substage adjustment operation, also through a blue or a green filter 44 or 45 and a pair of positive lenses 46 and 47 to a beam splitter 48. Light integrator 42 is fixedly mounted in the vertically extending portion 34c of optical path 34a-e and is employed for providing the beam of light passing therethrough with a cross section corresponding to the entrance pupil of projection lens 18 and with a uniform intensity distribution in the plane of reticle 12.

Shutter 50 is pivotally mounted adjacent to the vertically extending portion 34c of optical path 34a-e and is controlled by a θ servo drive unit 51 for pivotal movement into that optical path (as shown in solid lines) when closed so as to block passage of the beam of light therealong and for pivotal movement out of that optical path (as shown in dashed lines) when opened so as to permit passage of the beam of light therealong. Blue filter 44 and green filter 45

-11-

are fixedly mounted in horizontally spaced relationship on a slide 52 which is in turn reciprocally mounted in a horizontal plane orthogonally intersecting the vertically extending portion 34c of optical path 34a-e. Slide 52 is moved along the Y axis under control of an air cylinder 54 to position either the blue filter 44 or the green filter 45 in the path of the beam of blue and green light passing upward along the vertically extending portion 34c of optical path 34a-e when shutter 50 is opened. Blue filter 44 is normally so positioned and therefore passes the blue light in the beam of light to the pair of positive lenses 46 and 47 while filtering out the green light and any other non-blue light that may still be present in the beam of light.

Positive lenses 46 and 47 are fixedly mounted in the vertically extending portion 34c of optical paths 34a-e to image the output of light integrator 42 at the entrance pupil of an imaging lens 56. A slide 58 is mounted for movement along the Y axis under control of a Y axis servo drive unit 66 to selectively position either of two separate mask plates 60 and 62 at an operative position directly between positive lenses 46 and 47 in a horizontal plane orthogonally intersecting the vertically extending portion 34c of optical path 34a-e at a point midway between those positive lenses. Light appearing in this plane between positive lenses 46 and 47 is imaged onto reticle 12. During the substage adjustment operation, slide 58 is moved by Y axis servo drive unit 66 to locate mask plate 62 in an operative position between positive lenses 46 and 47.so that a pair of small circular openings 68a and 68b of mask plate 62 (best shown in Figure 4), permit the blue light passed by blue filter 44 to illuminate a corresponding pair of circular areas about 2 millimeters in diameter disposed on the surface of reticle 12 and containing a pair of reticle alignment marks 78a and 78b, respectively.

Beam splitter 48 is fixedly mounted in the vertically extending portion 34c of optical path 34a-e so as to reflect eighty percent of the incident light along a horizontally extending portion 34d of that optical path through imaging lens 56 to a plane mirror 70. Imaging lens 56 is fixedly mounted along the horizontally extending portion 34d of optical path 34a-e and is employed to image the light passing through mask plate 62 at the surface of reticle 12. Plane mirror 70 is fixedly mounted in optical path 34a-e at an angle of forty-five degrees with respect to the horizontally extending portion 34d thereof so as to deflect the light incident thereon downward along a vertically extending portion 34e of that optical path. This downwardly deflected light passes through a positive lens 72, reticle 12, and beam splitter 21 to projection lens 18. Positive lens 72 is fixedly mounted along the vertically extending portion 34e of optical path 34a-e so as to image light appearing at the output pupil of imaging lens 56 at the input pupil of projection lens 18.

With reference now particularly to Figures 1A and 2, each reticle 12 to be employed with alignment and exposure system 10 has a pair of oppositely-facing reticle alignment marks 78a and 78b spaced 103 millimeters apart (center-to-center) along the X axis when the reticle is properly aligned on stage 16. As best shown in Figure 5, each reticle alignment mark 78a or 78b may comprise a pair of light or transparent windows 80a and 80b (each about 0.75 millimeters square) on a dark or opaque field. These windows 80a and 80b are symmetrically disposed about the center 82 of the alignment mark on opposite sides of a pair of orthogonal centerlines of the alignment mark (one of those centerlines being coincident with a common centerline of both alignment marks). Stage 16 is provided with a vacuum holder 17, as shown in Figure 2, for releasably holding reticle 12 in place, and is moved by X and differentially-controlled Y axes servo drive units 84, 86a, and 86b to adjust the X, Y, and θ orientation of the reticle as required to precisely align the reticle alignment marks 78a and 78b of the reticle with reference mark 26 as hereinafter explained.

Beam splitter 21 is mounted in the vertically extending portion 34e of optical path 34a-e so as to pass eighty percent of the light passing through reticle 12 to projection lens 18, which is also mounted in that portion of optical path 34a-e. A compensating lens 76 is pivotally mounted adjacent to projection lens 18 and controlled by a crank 74 and an air cylinder 75 for movement out of the vertically extending portion 34e of optical path 34a-e (as shown in solid lines) when blue light is passing therealong to the projection lens, as is normally the case, and for movement into the vertically extending portion 34e of that optical path (as shown in dashed lines) when green light is passing therealong to the projection lens. The compensating lens 76 is employed to compensate for the difference in wavelength of the green light and the blue light since projection lens 18 is corrected for the blue light only.

Projection lens 18 focuses the light passing through

0111661

reticle 12 at the first image plane 77 adjacent to main stage 20 and directly beneath the projection lens, thereby projecting images of illuminated portions of reticle 12 (and, hence, of the reticle alignment marks 78a and 78b contained on the reticle and illuminated by mask plate 62 when shutter 50 is opened) onto whatever object is positioned in that image plane directly beneath the projection lens. The portions of that object onto which those images are projected are therefore illuminated by the blue light passing through the transparent reticle alignment marks 78a and 78b on reticle 12. Twenty percent of the light reflected vertically upward from those portions of that object through projection lens 18 is reflected by beam splitter 21 along horizontally extending portions 87a of a dual optical path 87a-f to a second image plane 79 positioned the same optical distance from the beam splitter as is the reticle 12 and positioned between the beam splitter and objective lenses 88a and 88b of compound microscope 22. Projection lens 18 focuses this reflected light at the second image plane 79 thereby projects an aerial image of those portions of the object positioned in the first image plane 77 directly beneath the projection lens (i.e., those portions illuminated by the projected images of the reticle alignment marks 78a and 78b contained on the reticle 12) to the second image plane.

With reference now particularly to Figures 1C and 2, compound microscope 22 includes a first objective lens unit 90 employed in the substage adjustment operation being explained and in other precision alignment operations hereinafter explained, a second objective lens unit 92 employed in a precision prealignment operation hereinafter explained,

-15-

and a binocular lens unit 93 employed with both the first and the second objective lens units as hereinafter explained. The first objective lens unit 90 is mounted on a stage 96 horizontally movable along the X axis under control of an X axis servo drive unit 98 and vertically movable along a Z axis orthogonal to the X and Y axes under control of a Z axis servo drive unit 100. Each of the objective lenses 88a and 88b comprises a 5:1 objective lens mounted on an associated arm 89, which is in turn pivotally mounted on stage 96 and coupled by a gear mechanism 102 to a θ servo drive unit 104 (both of which are also mounted on stage 96) for moving the objective lenses closer together or further apart. Objective lenses 88a and 88b are disposed along corresponding one of the horizontally extending portions 87a of dual optical path 87a-f adjacent to the second image plane 79 for receiving light therefrom. Thus, the objective lenses 88a and 88b can be moved with respect to the second image plane 79 as desired for viewing any portions of the aerial image projected to that plane.

A separate beam bender 106 is mounted on each arm 89 along each horizontally extending portion 87a of dual optical path 87a-f for deflecting light passing through the corresponding objective lens 88a or 88b generally downward along a corresponding downwardly extending portion 87b of dual optical path 87a-f to another corresponding beam bender 108. Each beam bender 108 is mounted on the same arm 89 as the corresponding beam bender 106 for pivotal movement therewith as the objective lenses 88a and 88b are moved closer together or further apart. Beam benders 108 are mounted along the corresponding downwardly extending portions 87b of

-16-

dual optical path 87a-f for deflecting light from the corresponding beam benders 106 along corresponding horizontally extending portions 87c of dual optical path 87a-f to corresponding beam benders 110 from which that light is deflected along other corresponding horizontally extending portions 87c of dual optical path 87a-f to corresponding faces of a split field prism 112. Split field prism 112 in turn deflects light from each beam bender 110 in side-by-side relationship along a common horizontally extending portion 87c of dual optical path 87a-f through a field lens 114 to another beam bender 116. Beam benders 110, split field prism 112, and field lens 114 are fixedly mounted on stage 96 along the respective horizontally extending portions 87c of dual optical path 87a-f.

Beam bender 116 is mounted along the common horizontally extending portion 87c of dual optical path 87a-f for swivel movement thereabout and is disposed for deflecting light passing through field lens 114 downward along a downwardly extending portion 87d of that dual optical path through positive lenses 118 and 120 to a beam bender 122. Positive lenses 118 and 120 and beam bender 122 are mounted along the downwardly extending portion 87d of dual optical path 87a-f for swivel movement with beam bender 116 about the common horizontally extending portion 87c of that dual optical path, and to allow relative axial movement between positive lens 118 (which is fixedly mounted in a first tube 119 in fixed relation to beam bender 116) and positive lens 120 (which is fixedly mounted on a second tube 121 in fixed relation to beam bender 122, the first and second tubes 119 and 121 being slidably and coaxially disposed one within the other) as the length

-17-

of the downwardly extending portion 87d of the dual optical path is changed by relative movement of beam benders 116 and 122. Thus, the downwardly extending portion 87d of dual optical path 87a-f may be moved by a manually controlled X axis slide 123, on which beam bender 122 is mounted, to locate beam bender 122 in an operative position along a horizontally extending portion 87e of dual optical path 87a-f whenever the first objective lens unit 90 is to be employed with binocular lens unit 93, such as in the substage adjustment operation. In this operative position beam bender 122 deflects light passing through positive lenses 118 and 120 forward along the horizontally extending portion 87e of dual optical path 87a-f to a beam bender 124. This beam bender 124 is fixedly mounted along the horizontally extending portion 87e of dual optical path 87a-f for deflecting light from beam bender 122 upward along a vertically extending portion 87f of dual optical path 87a-f to ocular lenses 126 of binocular head 94, which is fixedly mounted along that portion of the dual optical path.

The various elements of the first objective lens unit 90 and binocular lens unit 93 are arranged along dual optical path 87a-f as described above so that the aerial image viewed in the second image plane 79 by objective lenses 88a and 88b in reimaged at a third image plane 113 directly in front of split field prism 112. Positive lens 118 is provided with a focal length equal to the distance back along dual optical path 87a-f to the third image plane 113, and positive lens 120 is provided with a focal length equal to the distance forward along that dual optical path to a fourth image plane 127 directly in front of ocular lenses 126. Positive lenses

0**11661**

118 and 120 therefore serve as a relay lens unit for reimaging the reimaged image appearing in the third image plane 113 at the fourth image plane 127 and for accommodating changes in the length of the downwardly extending portion 87d of dual optical path 87a-f while transmitting light passing between those positive lenses in parallel rays as required to maintain proper focus.

As shown in Figure 2 and described in copending U.S. Patent Application Serial No. , entitled OPTICAL FOCUSING SYSTEM, filed on the same day as the present application by Edward H. Phillips, and incorporated by reference herein, stage 16, beam splitter 21, and projection lens 18 (and, hence, also compensating lens 76) are securely mounted on a tower 2. This tower 2 comprises an upper platform 3 on which stage 16 and beam splitter 21 are mounted, six upright rods 4 on which the upper platform is securely mounted, and a base 5 on which the rods 4 and the projection lens 18 (and, hence, compensating lens 76) are securely mounted. Stage 16, the reticle holder 17 mounted thereon, and the upper platform 3 of tower 2 are provided with clearance openings 6 permitting light passing through the reticle 12 to pass along the vertically extending portion 34e of dual optical path 34a-f through projection lens 18 to whatever object is positioned directly beneath the projection lens. The base 5 of tower 2 is mounted by air bearings on a casting 7, which is in turn fixedly mounted on a granite block 8 on which main stage 20 is mounted as described in U.S. Patent Application Serial No. 015,713. Base 5 of tower 2 is vertically movable with respect to the casting 7 (and, hence, granite block 8) so as to permit vertical movement

-19-

of the tower and, hence, projection lens 18 relative to main stage 20 under control of an automatic optical focusing system described in U.S. Patent Application Serial No. All of the elements of the first objective lens unit 90 and of the binocular lens unit 93 are securely mounted on an upright portion 9 of casting 7, while all of the elements of the second objective lens unit 92 are securely mounted on an upright portion 10 of the base 5 of tower 2 for vertical movement with the tower 2. In addition, all of the elements of light source unit 24 shown in Figure 1B are mounted on an upright post (not shown) which is in turn rotatably mounted on casting 7 so as to permit those elements to be pivoted away from the other portions of alignment and exposure system 10 for ease of service.

Referring now to Figures 1A-C and 2, the substage adjustment operation is performed by employing the X and Y servo drive units 25 and 27 for moving main stage 20 so as to position reference mark plate 28 directly beneath projection lens 18 with the end portions (including tic marks 26b) of reference mark 26 (which is nominally oriented along the X axis) illuminated by the projected images of reticle alignment marks 78a and 78b (i.e., by the blue light passing through those reticle alignment marks) contained on reticle 12. Concomitantly, the X and Z axes servo drive units 98 and 100 and the θ servo drive unit 104 are employed for moving stage 96 and spacing objective lenses 88a and 88b of the first objective lens unit 90 so as to position those objective lenses for viewing the aerial images of the illuminated end portions of reference mark 26. Since prior to adjustment of substage 30, reference mark plate 28 is likely disposed adjacent to and intersecting, rather than in, the first image plane 77, both of these aerial images of the illuminated end portions of reference mark plate 28 will be out of focus (one end portion likely being disposed above the other end portion below the first image plane). While viewing these out-of-focus aerial images, the operator manually adjusts substage 30 with respect to the plane of main stage 20, and the automatic focusing system described in U.S. Patent No.

automatically moves tower 2 so as to track the average pivotal movement of the substage until both of these aerial images are brought into focus. At this point reference mark plate 28 is precisely positioned in and parallel to the first image plane 77, and the aerial images of the end portions of reference mark 26 illuminated by the projected images of reticle alignment marks 78a and 78b contained on reticle 12 are in focus.

While employing one of the objective lenses of the first objective lens unit (for example, the right hand objective lens 88b) to view one of the focused aerial images (for example, the aerial image of the end portion of reference mark 26 illuminated by the projected image of the right hand reticle alignment mark 78b), the operator employs the X axis servo drive unit 25 for moving main stage 20 back and forth along the X axis in a shuttle mode so as to alternately position each end portion of the reference mark in the projected image of the right hand reticle alignment mark 78b and thereby pass line 26a of the reference mark back and forth through that projected image as shown in Figure 6. If line 26a of reference mark 26 is not precisely aligned with the X axis of motion of main stage 20, this back-and-forth movement of the main stage causes the illuminated portion of line 26a to rise and fall within the projected image of the right hand reticle alignment mark 78b. The operator thereupon adjusts the angular position of substage 30 until the illuminated portion of line 26a of reference mark 26 does not rise and fall within the projected image of the right hand reticle alignment mark (i.e., remains in the position shown in Figure 6) as main stage 20 is moved back and forth. This precisely aligns line 26a of reference mark 26 with the X axis of motion of main stage 20 and establishes the reference mark as an absolute frame of reference for precision alignment operations to be performed with alignment and exposure system 10 as hereinafter explained.

A set of n difference reticles 12, each containing a different level of microcircuitry to be successively printed at each of an array of adjacent regions of semiconductive wafer 14 in alignment with other levels of microcircuitry previously printed or yet to be printed at those same regions, is employed in the fabrication of integrated circuits or the like from the semiconductive wafer. Following the substage adjustment operation (and one other set-up operation hereinafter described), alignment and exposure system 10 may be successively employed with each reticle 12 of the set to successively perform each of these step-and-repeat printing operations on every semiconductive wafer 14 of a batch of semiconductive wafers being processed by the alignment and exposure system, as described below. Either the first reticle 12 of the first set of reticles to be employed with alignment and exposure system 10 or a special set-up reticle may be employed to perform the previously-described substage

-22-

adjustment operation.

During each step-and-repeat printing operation, the reticle 12 being employed must first be precisely aligned with reference mark 26 on substage 30 and, hence, with the X axis of motion of main stage 20. This is accomplished by placing the reticle 12 on vacuum holder 17 of stage 16 in nominal alignment with the X axis of motion of main stage 20; by employing X and Y axis servo drive units 25 and 27 for moving the main stage to a position at which reference mark 26 is centered directly beneath projection lens 18 with the end portions of the reference mark nominally aligned with the images of the reticle alignment marks 78a and 78b of the reticle to be projected onto reference mark plate 28 when shutter 50 is opened; by employing Y axis servo drive unit 66 for moving slide 58 to a position at which mask plate 62 is located in the same operative position between positive lenses 46 and 47 as previously described; by employing θ servo drive unit 51 to open shutter 50 so as to illuminate the reticle alignment marks 78a and 78b on the reticle and, hence, the end portions of reference mark 26 falling within the projected images of those reticle alignment marks; by employing slide 123 for moving beam bender 122 to the operative position in the horizontally extending portion 87e of optical path 87a-f as described above; by employing the X axis, Z axis, and θ servo drive units 98, 100, and 104, to position the objective lenses 88a and 88b for viewing the aerial images of the end portions of reference mark 26 illuminated by the images of the reticle alignment marks 78a and 78b projected onto those end portions; and while viewing those aerial images, by employing the X axis and differential

-23-

Y axis servo drive units 84, 86a, and 86b for moving reticle 12 to precisely align the images of the reticle alignment marks 78a and 78b contained on the reticle with the illuminated end portions of reference mark 26 as shown in Figure 7. When so aligned the images of transparent windows 80a and 80b of each reticle alignment mark 78a and 78b are symmetrically disposed with respect to the line 26a and intersecting tic mark 26b of the respective end portion of reference mark 26. It should be noted that many of the foregoing steps of the reticle alignment operation will already have been performed in the case of the first reticle of the first set of reticles being employed with alignment and exposure system 10 if that reticle is initially employed, rather than a special set-up wafer, in performing the previously described substage adjustment operation.

Once the first reticle 12 of the set has been aligned with reference mark 26 as described above, a pair of spaced wafer alignment marks 130a and 130b contained on the first reticle is printed on each semiconductive wafer 14 of the batch of semiconductive wafers being processed by alignment and exposure system 10. The wafer alignment marks 130a and 130b printed on semiconductive wafer 14 are employed to precision prealign the semiconductive wafer, as hereinafter explained in preparation for each step-and-repeat printing operation. The same pair of wafer alignment marks 130a and 130b can be employed in preparation for every step-and-repeat printing operation to be formed on semiconductive wafer 14 so long as that pair of wafer alignment marks does not become obliterated or obscured during those step-and-repeat printing operations or other processing operations following each step-and-repeat printing operation. Additional pairs of wafer alignment marks 130a and 130b may also be contained on the first reticle 12 and printed on semiconductive wafer 14 during the same wafer alignment mark printing operation in the event they should later be required.

The wafer alignment marks 130a and 130b contained on the first reticle 12 are spaced 103 millimeters apart and are disposed directly adjacent to and behind reticle alignment marks 78a and 78b. As best shown in Figure 8, each of these wafer alignment marks 130a and 130 comprises a light or transparent cross (with orthogonal bars 132a and 132b) disposed on a dark or opaque field. In preparation for printing these wafer alignment marks 130a and 130b on each semiconductive wafer 14 of the batch being processed by alignment and exposure system 10, a photosensitive film is deposited over each semiconductive wafer of the batch. The wafer alignment mark printing operation is then successively performed on each semiconductive wafer 14 of the batch in the same manner as will now be described for the first semiconductive wafer of the batch.

The first semiconductive wafer 14 is placed on a vacuum chuck 131 mounted on main stage 20 for differential movement with respect to the plane of the main stage to permit parallel-plane alignment and focusing of the upper surface of the semiconductive wafer in the first image plane 77 as described in detail in U.S. Patent Application Serial No.
The left hand wafer alignment mark 130a contained on the first reticle 12 is printed on the left hand side of the first semiconductive wafer 14 by employing Y axis servo drive unit 66 for moving slide 58 to locate mask plate 62 in an operative position between positive lenses 46 and 47 so as to illuminate small circular portions of the reticle containing the left and right hand wafer alignment marks 130a and 130b with blue light when shutter 50 is subsequently opened; by employing X and Y axes servo drive units 25 and 27 for moving main stage 20 to a position at which the left hand side of the semiconductive wafer is disposed directly beneath projection lens 18 so that when shutter 50 is subsequently opened the left hand wafer alignment mark 130a on the reticle will be imaged onto the left hand side of the semiconductive wafer at a location along a center line 134 thereof parallel to the X axis and at a distance from the center 136 of the semiconductive wafer equal to half the objective spacing of the second objective lens unit 92, while the right hand wafer alignment mark 130b on the reticle will be imaged off and to the left of the semiconductive wafer, as shown in Figure 9A; and by thereupon momentarily opening shutter 50 so that blue light passing through the aforementioned small circular portion of the reticle containing the left hand wafer alignment mark 130a selectively exposes a corresponding portion of the photosensitive film deposited on the semiconductive wafer and thereby prints that left-hand wafer alignment mark 130a on the semiconductive wafer at the aforementioned location. Similarly, the right hand wafer alignment mark 130b contained on the first reticle 12 is then printed on the right hand side of the first semiconductive wafer 14 by employing X and Y axes servo drive units 25 and 27 for moving main stage 20 to a position at which the right hand side of the semiconductive wafer is disposed directly beneath projection lens 18 so that when shutter 50 is subsequently opened the right hand wafer alignment mark 130b on the reticle will be imaged onto the right hand side of the semiconductive wafer at a location along centerline 134 thereof parallel to the X axis and at a distance from the center 136 of the semiconductive wafer equal to half the objective spacing of the second objective lens unit 92, while the left hand wafer alignment mark 130a on the reticle will be imaged off and to the right of the semiconductive wafer, as shown in Figure 9B; and by thereupon momentarily opening shutter 50 so that blue light passing through the aforementioned small circular portion of the reticle containing the right hand wafer alignment mark 130b selectively exposes a corresponding portion of the photosensitive film deposited on the semiconductive wafer and thereby prints that right hand wafer alignment mark 130b on the semiconductive wafer at the aforementioned location. Following the foregoing wafer alignment mark printing operation, the first semiconductive wafer 14 is removed from alignment and exposure system 10 and is subsequently processed in accordance with well known techniques to develop the selectively exposed photosensitive film thereon, and for example, to etch the wafer alignment marks 130a and 130b printed on the semiconductive wafer into the semiconductive wafer.

In initially setting up alignment and exposure system 10 left and right hand prealignment reticles 138a and 138b are manually adjusted (by adjustment screws not shown) to precisely align left and right hand wafer alignment marks 140a and 140b respectively contained thereon with the X axis of motion of main stage 20 as hereinafter explained. These wafer alignment marks 140a and 140b are identical to reticle alignment marks 78a and 78b contained on reticle 12 but are spaced apart along the X axis in correspondence with the objective spacing of the second objective lens unit 92 and, hence, with the spacing of the wafer alignment marks 130a and 130b previously printed and then etched or otherwise formed on each semiconductive wafer 14. Thus, once a semiconductive wafer 14 has been put back in alignment and exposure system 10 and placed on vacuum chuck 131, it may quickly be precisely aligned with respect to the X axis of motion of main stage 20 and, hence, with respect to reticle 12 by simply employing the X and Y axes servo drive units 25 and 27 for moving the main stage to align the wafer alignment marks 130a and 130b on the semiconductive wafer with the corresponding wafer alignment marks 140a and 140 contained on prealignment reticles 138a and 138b, respectively.

The first semiconductive wafer 14 of the first batch of semiconductive wafer being processed by alignment and exposure system 10 can be used in performing the prealignment reticle adjustment operation. In order to do this the first semiconductive wafer 14 has to be precisely aligned with the first reticle 12 of the first set of reticles being employed with alignment and exposure system 10 and, hence, with the X axis of motion of main stage 20 so as to become a secondary frame of reference for use in aligning prealignment reticles 138a and 138b with the X axis motion of the main stage. This is accomplished by placing the first semiconductive wafer 14 on vacuum chuck 131 in nominal alignment with the first reticle 12; by employing the θ servo drive unit 51 to open shutter 50; by employing the Y axis servo drive unit 66 for moving slide 58 to position mask plate 62 at an operative position between positive lenses 46 and 47 so as to illuminate small circular regions of reticle 12 containing the left and right hand reticle alignment marks 78a and 78b as previously described in connection with the substage adjustment and reticle alignment operations; by returning slide 123 and objective lenses 88a and 88b of the first objective lens unit 90 to the positions described above in connection with the reticle alignment operation, if slide 123 and objective lenses 88a and 88b are not already in those positions (however, they should in fact already be in those positions since they do not need to be moved therefrom during alignment of the first reticle of the first set with the reference mark 26 or during subsequent printing of the wafer alignment marks 130a and 130b on the first semiconductive wafer 14); and by employing main stage 20 to perform successive X axis, θ rotational, and Y axis alignments of the wafer alignment marks 130a and 130b on the first semiconductive wafer with respect to the projected images of the illuminated reticle alignment marks 78a and 78b contained on the first reticle.

The X axis alignment of wafer alignment marks 130a and 130b with respect to the projected images of reticle alignment marks 78a and 78b may be performed by employing the X and Y axes servo drive units 25 and 27 for moving main stage 20 to position the left hand wafer alignment mark 130a directly beneath the projected image of the left-hand reticle alignment mark 78a; by employing the left hand objective lens 88a of the first objective lens unit 90 to view the aerial image of portions of the left hand wafer alignment mark 130a illuminated by the projected image of the left hand reticle alignment mark 78a; and, while viewing that aerial image, by further employing the servo drive units 25 and 27 for moving the main stage to align the left hand wafer alignment mark 130a symmetrically with respect to the projected image of the left hand reticle alignment mark 78a as shown in Figure 10A. This should normally be effective to complete the X axis alignment of both wafer alignment marks 130a and 130b formed on the first semiconductive wafer with respect to the projected images of the corresponding reticle alignment marks 78a and 78b contained on the first reticle 12.

The θ rotation alignment of wafer alignment marks 130a and 130b with respect to the projected images of the reticle alignment marks 78a and 78b may next be performed by employing the X axis servo drive unit 25 for moving main stage 20 to position the right hand wafer alignment mark 130b beneath the projected image of the right hand reticle alignment mark 78b; by employing the right hand objective lens 88b of the first objective lens unit 90 to view the aerial image of portions of the right hand wafer alignment mark 130b illuminated by the projected image of the right hand reticle alignment mark 78b; and, while viewing that aerial image, by employing a θ servo drive unit 29 for rotating chuck 131 on the main stage to move the right hand wafer alignment mark 130b as shown in Figure 10B from its original position (indicated in dashed lines) to an intermediate position (indicated in solid lines) approximately half the rotational distance (center-to-center) between its original position and the position of the projected image of the right hand reticle alignment mark 78b. This has the effect of moving both wafer alignment marks 130a and 130b formed on the first semiconductive wafer 14 into nominal θ rotational alignment with the

-30-

projected images of the corresponding reticle alignment marks 78a and 78b contained on the first reticle 12. Each of these wafer alignment marks 130a and 130b is therefore offset approximately the same distance (center-to-center) along the Y axis from the projected image of the corresponding reticle alignment mark 78a or 78b as may be seen by comparing the intermediate position of the right hand wafer alignment mark 130b (indicated in solid lines in Figure 10B) relative to the projected image of the right hand reticle alignment mark 78b and the intermediate position of the left hand wafer alignment mark 130a (indicated in solid lines in Figure 10C) relative to the projected image of the left hand reticle alignment mark 78a.

The Y axis alignment of wafer alignment marks 130a and 130b with respect to the projected images of reticle alignment marks 78a and 78b may be performed by employing the X axis servo drive unit 25 for moving main stage 20 to position the left hand wafer alignment mark 130a beneath the projected image of the left hand reticle alignment mark 78a; by employing the left hand objective lens 88a of the first objective lens unit 90 to view the aerial image of the left hand wafer alignment mark 130a illuminated by the projected image of the left hand reticle alignment mark 78a as shown in Figure 10C; and, while viewing that aerial image, by employing the Y axis servo drive unit 27 and, if necessary, the X axis servo drive unit 25 for moving the main stage to align the left hand wafer alignment mark 130a symmetrically with respect to the projected image of the left hand reticle alignment mark 78a as shown in Figure 10. This has the effect of moving both wafer alignment marks 130a and 130b

-31-

formed on the first semiconductive wafer 14 into nominal Y axis alignment with the projected image of the corresponding reticle alignment marks 78a and 78b contained on the first reticle 12.

As mentioned above, the X axis alignment of both wafer alignment marks 130a and 130f formed on the first semiconductive wafer 14 with respect to the projected images of the corresponding reticle alignment marks 78a and 78b contained on the first reticle 12 should be completed at the end of the initial X axis alignment step. However, if any X axis misalignment should remain, it will be observed and can be eliminated while performing the Y axis alignment step. Due to the difficulty of precisely estimating half the rotational distance (center-to-center) between the right-hand wafer alignment mark 130b and the projected image of the corresponding reticle alignment mark 78b during the θ rotational alignment step and due also to the resulting differences in the distances the left and right hand wafer alignment marks 130a and 130b are offset along the Y axis from the projected images of the corresponding reticle alignment marks 78a and 78b (center-to-center), several iterations of the θ rotational and Y axis alignment steps are normally required to complete those alignments. Each such iteration of the θ rotational and Y axis alignment steps should reduce any θ rotational and Y axis misalignments by at least half.

Once the X axis, θ rotational, and Y axis alignments of both wafer alignment marks 130a and 130b on the first semiconductive wafer 14 with respect to the projected images of the corresponding reticle alignment marks 78a and 78b on the first reticle 12 have been completed (i.e., any X axis, θ

-32-

rotational, and Y axis misalignments have become unobservable with the first objective lens unit 90), the wafer alignment marks 130a and 130b of the first semiconductive wafer are precisely aligned with respect to the X axis of motion of main stage 20. The first semiconductive wafer 14 has therefore become a secondary frame of reference that may now be employed for aligning the wafer alignment marks 140a and 140b contained on prealignment reticles 138a and 138b, respectively, with the X axis of motion of main stage 20 during the prealignment reticle adjustment operation. Accordingly, the X and Y axes servo drive units 25 and 27 are employed for moving main stage 20 to locate the first semiconductive wafer 14 in the prealignment position shown in Figure 1. In this position the left and right hand wafer alignment marks 130a and 130b on the first semiconductive wafer 14 are disposed beneath the corresponding left and right hand wafer alignment marks 140a and 140b on the left and right hand prealignment reticles 138a and 138b, respectively, and equidistantly along the X axis with respect to the optical axis of projection lens 18. The manner in which the prealignment reticle adjustment operation is performed will now be described with reference to the parts of alignment and exposure system 10 employed in that operation.

With reference now particularly to Figures 1A, 1C and 2, each of the prealignment reticles 138a and 138b is mounted along a corresponding vertically extending portion 142a of a dual optical path 142a-c (on the upright portion 10 of the base 5 of tower 2) for both pivotal movement about and translational movement relative to that portion of dual optical path 142a-c (as manually controlled by adjustment screws not shown) so as to permit alignment of the wafer alignment mark 140a or 140b contained thereon with the corresponding wafer alignment mark 130a or 130b formed on the first semiconductive wafer 14. A separate fiber optical light pipe 144 is fixedly mounted at one end along each of the vertically extending portions 142a of dual optical path 142a-c directly above the corresponding prealignment reticle 138a or 138b. The other end of each of these fiber optic light pipes 144 is optically coupled to a secondary light source 146 of the projection lamp type for emitting illuminating light having a wavelength of 525 nanometers or greater. Illuminating light from this secondary light source 146 passes through fiber optic light pipes 144 and downwardly along the vertically extending portions 142a of dual optical path 142a-c through the corresponding prealignment reticles 138a and 138b.

The second objective lens unit 92 includes a separate beam splitter 148 fixedly mounted along each of the vertically extending portions 142a of dual optical path 142a-c for transmitting fifty percent of the light passing through the corresponding prealignment reticle 138a or 138b downwardly along that portion of dual optical path 142a-c. It also includes left and right hand objective lenses 150a and 150b each comprising a 10:1 objective lens fixedly mounted along a corresponding different one of the vertically extending portions 142a of dual optical path 142a-c directly below the corresponding beam splitter 148. When the first semiconductive wafer 14, or any subsequent semiconductive wafer, is located in the prealignment position shown in Figure 1, these left and right hand objective lenses 150a and 150b are disposed directly above left and right hand portions of the semiconductive

-34-

wafer that contain the left and right hand wafer alignment marks 130a and 130b, respectively, since those wafer alignment marks were spaced apart along the X axis by a distance equal to the objective spacing of the second objective lens unit 92 as described above. The left and right hand objective lenses 150a and 150b focus the light passing through the corresponding left and right hand prealignment reticles 138a and 138b and the corresponding beam splitters 148 at the first image plane 77 adjacent to main stage 20 and directly beneath those objective lenses, thereby projecting images of the left and right hand wafer alignment marks 140a and 140b contained on those prealignment reticles onto the corresponding left and right hand wafer alignment mark containing regions of the semiconductive wafer 14 located in the prealignment position. Fifty percent of the light reflected vertically upward from each of these left and right hand wafer alignment mark containing regions of semiconductive wafer 14 through the corresponding objective lens 150a and 150b is reflected by the corresponding beam splitter 148 along a horizontally extending ortion 142b of dual optical path 142a-c.

The second objective lens unit 92 also includes a separate beam bender 152 fixedly mounted along each horizontally extending portion 142b of dual optical path 142a-c adjacent to the corresponding beam splitter 148 so as to deflect the reflected light therefrom to a corresponding face of a split field prism 154. Split field prism 154 is fixedly mounted along both horizontally extending portions 142b of dual optical path 142a-c as to deflect the reflected light from each beam bender 152 in side-by-side relationship along a common horizontally extending portion 142c of dual

-35-

optical path 142a-c to a fifth image plane 155 positioned directly in front of split field prism 154 and the same optical distance from beam splitters 148 as are prealignment reticles 138a and 138b. A 5:1 objective lens 156 is fixedly mounted along the common horizontally extending portion of dual optical path 142a-c for viewing the fifth image plane. The horizontally extending portion 142c of dual optical path 142a-c is axially aligned with the horizontally extending portion 87e of dual optical path 87a-f to permit use of the first and second objective lens units 90 and 92 with the same binocular lens unit 93 as determined by the position of slide 123. Accordingly, a positive lens 158 is fixedly mounted on slide 123 for movement into an operative position in those axially aligned horizontally extending portions 87e and 142c of dual optical paths 87a-f and 142a-c between beam bender 124 and objective lens 156, as shown in Figures 1C and 11, when the second objective lens unit 92 is to be employed. With positive lens 158 so positioned, light from objective lens 156 passes through positive lens 158 and along horizontally extending portion 87e of dual optical path 87a-f to beam bender 124 from which it is deflected upward along vertically extending portion 87f of dual optical path 87a-f to the fourth image plane 127 directly in front of ocular lenses 126 of binocular head 94.

The various elements of the second objective lens unit 92 are arranged along dual optical path 142a-c as described above so that objective lenses 150a and 150b focus the light reflected from the left and right hand wafer alignment mark containing regions of the semiconductive wafer 14 disposed in the prealignment position at the fifth image plane 155 directly in front of split field prism 154. This provides aerial images of the left and right hand wafer alignment marks 130a and 130b disposed on the semiconductive wafer in the first image plane 77 directly beneath objective lenses 150a and 150b, and of the images of the corresponding left and right hand wafer alignment marks 140a and 140b contained on the prealignment reticles 138a and 138b and projected onto the semiconductive wafer directly beneath those objective lenses, in the fifth image plane 155. Objective lens 156 has a focal length equal to the distance from its input pupil back along the horizontally extending portion 142c of dual optical path 142a-c to the fifth image plane. Positive lens 158, when positioned in the axially aligned horizontally extending portions 87e and 142c of dual optical paths 87a-f and 142a-c, has a focal length equal to the distance forward along portions 87e and 87f of dual optical path 87a-f to the fourth image plane 127 directly in front of ocular lenses 126 of binocular head 94. Objective lens 156 and positive lens 158 therefore reimage the aerial images provided in the fifth image plane 155 at the fourth image plane 127.

The prealignment reticle adjustment operation may therefore be performed by employing slide 123 to move positive lens 158 into the operative position in the axially aligned horizontally extending portions 87e and 142c of dual optical paths 87a-f and 142a-c; by thereupon employing binocular lens unit 93 with the second objective lens unit 92 to view the aerial images of those portions of the left and right hand wafer alignment marks 130a and 130b disposed on the first semiconductive wafer 14 that are illuminated by the projected images of the corresponding wafer alingment marks 140a and 140b disposed on prealignment reticles 138a and 138b; and, while viewing those aerial images, by manually adjusting the prealignment reticles to position the projected images of the left and right hand wafer alignment marks 140a and 140b disposed thereon in precise θ rotational, X axis, and Y axis alignment with the corresponding left and right hand wafer alignment marks 130a and 130b disposed on the first semiconductive wafer as shown in Figure 12. This precisely aligns the prealignment reticles 138a and 138b with the X axis of motion of main stage 20 and positions them equidistantly along the X axis with respect to the optical axis of projection lens 18 so that they may subsequently be employed in the precision prealignment of other semiconductive wafers 14 without further adjustment. Although the prealignment reticle adjustment operation should not normally have to be repeated during the lifetime of alignment and exposure system 10, it may be checked at any time by employing another semiconduc-tive wafer in the same manner as described above for the first semiconductive wafer.

Each semiconductive wafer 14 processed by alignment and exposure system 10 subsequent to the prealignment reticle adjustment operation, may be precision prealigned with respect to the X axis of motion of main stage 20 and with respect to the optical axis of projection lens 18 by simply employing the X and Y axes servo drive units 25 and 27 for moving main stage 20 to position the semiconductive wafer in the prealignment position shown in Figure 1; by moving slide 123 to move positive lens 158 to the operative position; by employing binocular lens unit 93 to view the aerial images provided by the second objective lens unit 92 as described above; and, while viewing

0111661

those aerial images, by employing the X axis, Y axis, and θ servo drive units 25, 27, and 29 for moving the main stage and rotating vacuum chuck 17 to precisely align the left and right hand wafer alignment marks 130a and 130b formed on the semiconductive wafer with the corresponding left and right hand wafer alignment marks 140a and 140b contrained on the prealignment reticles 138a and 138b. Following the precision prealignment of a semiconductive wafer 14 it may be subjected to a step-and-repeat printing operation in the same manner as described below for the first semiconductive wafer 14.

Assuming that the first reticle 12 of the first set of reticles being employed with and the first semiconductive wafer 14 of the first batch of semiconductive wafers being processed by alignment and exposure system 10 were employed to perform the previously-described prealignment reticle adjustment operation (rather than a special set-up reticle and a special set-up wafer), the first semiconductive wafer is then removed from alignment and exposure system 10 so that a photosensitive film may be deposited over the first semi-conductive wafer along with the other semiconductive wafers of the same batch. The first semiconductive wafer 14 is thereafter placed back in alignment and exposure system 10 on vacuum chuck 17 and precision prealigned with prealignment reticles 138a and 138b as described above. Referring again to Figures 1A-C and 2, the first level of microcircuitry contained on a central portion 160 of the first reticle may now be printed at each of a desired array of adjacent regions 162 of the first semiconductive wafer as shown in Figure 13. This is accomplished by employing the Y axis servo drive

-39-

unit 66 for moving slide 58 to position mask plate 60 in an
operative position between positive lenses 46 and 47 with a
square central opening 69 of mask plate 60 permitting illumination of the entire microcircuitry-containing central portion 160 of the first reticle 12 held by vacuum holder 17
when shutter 50 is moved to the open position shown in dashed
lines in Figure 1; by employing the X and Y axes servo drive
units 25 and 27 to step main stage 20 so as to successively
position each of the desired array of adjacent regions 162 of
the first semiconductive wafer 14 held by vacuum chuck 17
directly beneath projection lens 18 in the order indicated by
the dashed arrows in Figure 13; and by employing the θ servo
drive unit 51 to momentarily move shutter 50 to the open position when each of those regions 162 of the first semiconductive
wafer is so positioned, thereby repetitively selectively exposing
the photosensitive film deposited on the first semiconductive
wafer so as to print the first level of microcircuitry contained
on the first reticle at each of those regions of the first
semiconductive wafer. The square central opening 68 of mask
plate 60 is of a size for permitting illumination of the entire
microcircuitry-containing central portion 160 of each reticle
12 (an area of about 100 millimeters or less square) as described above, while preventing illumination and, hence, printing
of the reticle alignment marks 78a and 78b and any wafer alignment marks 130a and 130b contained on the reticle, during the
step-and-repeat printing operation.

Following this step-and-repeat printing operation, the
first semiconductive wafer 14 is removed from alignment and
exposure system 10 and processed to develop the selectively
exposed photosensitive film thereon and to selectively etch,

0111661

diffuse, plate, implant or otherwise process the first semi-
conductive wafer in accordance with well known techniques
for forming the first level of microcircuitry on the first
semiconductive wafer at each of the desired array of adjacent
regions 162. Each additional semiconductive wafer 14 of the
first batch and every semiconductive wafer of every other
batch to be processed by alignment and exposure system 10
may also be processed with the first reticle 12 (and possi-
bly a second reticle as hereinafter explained) of the aforementioned set or any other set of reticles in exactly the
same manner as described above in connection with the first
semiconductive wafer of the first batch (except for the
prealignment reticle adjustment operation) to initially
print and form the left and right hand wafer alignment marks
130a and 130b (and possibly other alignment marks as hereinafter explained) on the semiconductive wafer and then to
step-and-repeatedly print the first level of microcircuitry
contained on the first reticle (or a second reticle as hereinafter explained) of the set of reticles at each of the
desired array of adjacent regions of the semiconductive wafer.
In this case each semiconductive wafer 14 is removed from
alignment and exposure system 10 following the initial
alignment mark printing operation to form the alignment
marks on the semiconductive wafer, for example, by a deep
etching operation, is then placed back in the alignment and
exposure system and precision prealigned in preparation for
the subsequent first step-and-repeat microcircuitry printing
operation, and is removed again from the alignment and
exposure system following the first step-and-repeat microcircuitry
printing operation to form the first level of microcircuitry

-41-

on the semiconductive wafer.

Alternatively, however, in cases where the steps of forming the wafer alignment marks and the first level of microcircuitry on a semiconductive wafer 14 (other than the first semiconductive wafer employed to perform the prealignment reticle adjustment operation) do not require inconsistent processing, such as different depths of etching, it is not necessary to remove the semiconductive wafer from alignment and exposure system 10 between the initial wafer alignment mark printing operation and the first step-and-repeat microcircuitry printing operation (the wafer alignment marks 130a and 130b then printed on the semiconductive wafer not being required for the prealignment reticle adjustment operation or for alignment of the first level of microcircuitry with a previously formed level of microcircuitry). In such cases the first step-and-repeat printing operation can be performed to print the first level of microcircuitry contained on the first reticle of the set at each of the desired array of adjacent regions 162 of the semiconductive wafer without first performing the precision prealignment operation. Upon completion of the first step-and-repeat printing operation, the semiconductive wafer 14 is removed for the first time from alignment and exposure system 10 and processed as previously indicated to form the wafer alignment marks 130a and 130b (and any other wafer alignment marks that may have also been printed as hereinafter described) on the semiconductive wafer and also to form the first level of microcircuitry at each of the desired array of adjacent regions 162 of the semiconductive wafer.

Once the first level of microcircuitry contained on

-42-

projected images of the reticle alignment marks 78a and 78b
with the illuminated end portions of reference mark 26
as previously shown in Figure 7).

The second level of microcircuitry contained on this
next reticle 12 of the set is thereupon printed and formed
at each of the desired array of adjacent retions 162 on
each semiconductive wafer 14 of the batch being processed
by alignment and exposure system 10 in alighment with the
first level of microcircuitry previously printed and formed
at each of those regions on each of those semiconductive
wafers. This is accomplished for each of those semiconductive
wafers 14 by deposition a photosensitive film over the semi-
conductive wafer; by placing the semiconductive wafer back
in alighment and exposure system 10 on vacuum chuck 17 in
nominal alignment with the X axis of motion of main stage 20;
by precision prealigning the semiconductive wafer in exactly
the same manner as previously described for the first semi-
conductive wafer being processed by the alignment and
exposure system (i.e., by employing the X and Y axes servo
drive units 25 and 27 for moving the main stage to locate
the semiconductive wafer in the prealignment positio n;
by employing slide 123 to move positive lens 158 into
the operative position in the axially aligned horizontally
extending portions 87e and 142c of dual optical paths
87a-f and 142a-c and thereby permit use of the second
objective lens unit 92 with binocular lens unit 93 for viewing
the aerial images of the left and right hand wafer alignment
marks 130a and 130b disposed on the semiconductive wafer
and illuminated by the projected images of the corresponding left
and right hand wafer alignment marks 140a and 140b disposed
on the prealignment reticles 138a and 138b and, while

-44-

the first reticle 12 (or the second reticle as hereinafter described) of the set of reticles being employed with alignment and exposure system 10 has been printed and formed on each of the desired array of adjacent regions 162 of each semiconductive wafer 14 of the batch or batches being processed with the alignment and exposure system, that reticle is removed from the vacuum holder 17 of stage 16. The next reticle 12 of the set is then placed on the vacuum holder 17 of stage 16 in nominal alignment with the X-axis of motion of main stage 20 and is thereupon precisely aligned with the X axis of motion in exactly the same manner as previously described for the first reticle of the set (i.e., by employing the X and Y axes servo drive units 25 and 27 for moving the main stage to position reference mark 26 directly beneath projection lens 18; by employing Y axis servo drive unit 66 for moving slide 58 to position mask plate 62 in an operative position between positive lenses 46 and 47 so as to illuminate the reticle alignment marks 78a and 78b on the reticle when shutter 50 is opened by employing θ servo drive unit 51 to open shutter 50; by employing slide 123 to move beam bender 122 into the operative position in the horizontally extending portion 87e of dual optical path 87a-f and thereby permit use of the first objective lens unit 90 with binocular lens unit 93 for viewing the aerial images of the end portions of reference mark 26, which are illuminated by the projected images of the objective lenses 88a and 88b for viewing those aerial images; and, while viewing those aerial images, by employing the X axis and differential Y axis servo drive units 84, 86a and 86b for moving stage 16 so as to precisely align the viewing those aerial images, by employing the X axis, Y axis, and θ servo drive units 25, 27, and 29 for moving the main stage and rotating the vacuum chuck so as to precisely align the left and right hand wafer alignment marks 130a and 130b on the semi-conductive wafer with the projected images of the corresponding left and right hand wafer alignment marks 150a and 150b on the prealignment reticles); by then step-and-repeat printing the second level of microcircuitry contained on the central portion 160 of the reticle at each of the same desired array of adjacent regions 162 of the semiconductive wafer in exactly the same manner as also previously described for the first semiconductive wafer being processed by the alignment and exposure system (i.e., by employing the Y axis servo drive unit 66 for moving slide 58 so as to position mask plate 60 in an operative position between positive lenses 46 and 47 and thereby illuminate the entire microcircuitry-containing central portion 160 of the reticle when shutter 50 is opened; by employing the X and Y axes servo drive units 25 and 26 for stepping the main stage to successively position each of the same desired array of adjacent regions 162 of the semiconductive wafer directly beneath projection lens 18 in the same order as before; and by employing the θ servo drive unit 51 to momentarily open shutter 50 when each of those regions 162 of the semiconductive wafer is so positioned and thereby repetitively selectively expose the photosensitive film deposited on the semiconductive wafer so as to print the second level of microcircuitry contained on the reticle at each of those regions 162 of the semiconductive wafer); by thereupon removing the semiconductive wafer from the

-45-

alignment and exposure system; and by subsequently process-
ing the semiconductive wafer to develop the selectively exposed
photosensitive film thereon and form the second level of
microcircuitry at each of the same desired array of adjacent
regions 162 of the semiconductive wafer.

The foregoing reticle alignment and wafer alighment,
printing, and processing operations are repeated for each
remaining reticle 12 of the set of reticles being employed
with alignment and exposure system 10 in processing each
semiconductive wafer 14 of the batch of semiconductive wafers
being processed by the alignment and exposure system so
as to print and form each successive level of microcircuitry
contained on those reticles at each of the same desired
array of adjacent regions 162 on each of those semiconductive
wafers in alignment with the levels of microcircuitry previously
formed at each of those same regions on each of those
semiconductive wafers.  Following completion of this processing
each semiconductive wafer 14 is typically scribed alongside
each row and column of the desired array of adjacent regions
162 of the semiconductive wafer so as to form a plurality
of individual die each containing one of the regions 162.
These dice are then typically subjected to die bonding,
wire bonding, and other well known processing operations
to form integrated circuits or the like.

Alignment and exposure system 10 may also be used to
perform a precision alignment step-and-repeat printing
operation permitting each level of microcircuitry to be
successively printed at each of the same desired array of
adjacent regions 162 of each semiconductive wafer 14 in
even more precise alignment with any level or levels of
microcircuitry previously printed and formed at each of

-46-

those same regions than could otherwise be achieved with the aid of the above-identified prealignment operation alone. In order to perform this precision alignment step-and-repeat printing operation, the first reticle 12 of the set of reticles being employed with alignment and exposure system 10 is also provided, as shown in Figure 14, with a set of small wafer alignment marks 170 vertically arranged in a column, for example, in the marginal portion of the first reticle along the Y axis (assuming the first reticle is held by vacuum holder 17 of stage 16 in alignment with the X axis of motion of main stage 20 as previously described) and between one side of the microcircuitry-containing portion 160 of the first reticle and the reticle and wafer alignment marks 78b and 130b also contained on the first reticle. These small wafer alignment marks 170 lie within the square area of the first reticle illuminated when mask plate 60 is disposed in its operative position between positive lenses 46 and 47 and shutter 50 is opened (as during the above-described step-and-repeat printing operation). The small wafer alignment marks 170 may comprise crosses of the same type as the wafer alignment marks 130a and 130b (i.e., light or transparent lines oriented parallel to those of wafer alignment marks 130a and 130b and disposed on a dark or opaque field), but are substantially smaller and are equal in number to the n-1 remaining reticles of the set. In the case where the set of small wafer alignment marks 170 is contained on the first reticle 12 of the set along with the first level of microcircuitry, the set of small wafer alignment marks 170 is automatically printed with and alongside each of the desired array of adjacent regions 162 of the semiconductive wafer 14 during

-47-

the first step-and-repeat printing operation performed on the semiconductive wafer. The sets of small wafer alignment marks 170 so printed may be formed along side each of the desired array of adjacent regions 162 of the semiconductive marker 14, for example, by an etching operation performed during subsequent processing of the semiconductive wafer to form the first level of microcircuitry at each of those regions.

Alternatively, however, in a case where it is desired to form the left and right hand wafer alignment marks 130a and 130b and the set of smaller wafer alignment marks 170, for example, by a deeper etching operation than may be desired in forming the first level of microcircuitry, the left and right hand wafer alignment marks 130a and 130b and the set of smaller wafer alignment marks 170 may be provided on the first reticle 12 of the set in the same positions shown in Figure 14 and the first level of microcircuitry may be provided on the central portion 160 of the second reticle of the set in the same position shown in Figures 1A and 14. In such a case, the set of small wafer alighment marks 170 may then be printed alongside as many of the desired array of adjacent regions 162 of the semiconductive wafer 14 (ranging from a minimum of, for example, one of those regions per quadrant of the semiconductive wafer to a maximum of, for example, all of those regions] as deemed appropriate by the operator. This may be done immediately following the previously-described operation of printing the left and right hand wafer alignment marks 130a and 130b contained on the first reticle 12 of the set onto the semiconductive wafer 14.

The small wafer alignment mark printing operation is performed by employing the Y axis servo drive unit 66 for moving slide 58 to position mask plate 60 in its operative position between positive lenses 46 and 47 and thereby illuminate the entire central portion 160 of the reticle 12 and the set of small wafer alignment marks 170 (but not the reticle alignment marks 78a and 78b or the wafer alignment marks 130a and 130b) when shutter 50 is opened; by employing the X and Y axes servo drive units 25 and 27 for stepping main stage 20 to successively position selected ones of the regions 162 alongside which the operator desires to print the set of small wafer alignment marks 170 (such as, for example, a selected one of those regions per quadrant of the semiconductive wafer), directly beneath projection lens 18; and by employing the θ servo drive unit 51 to momentarily open shutter 50 when each of those selected regions 162 of the semiconductive wafer is so positioned and thereby repetitively selectively expose the photosensitive film deposited on the semiconductive wafer so as to print the entire set of smaller wafer alignment marks 170 contained on the first reticle alongside each of those selected regions 162 on the semiconductive wafer. The right and left hand wafer alignment marks 130a and 130b and the sets of smaller wafer alignment marks 170 so printed may thereupon be formed on the semiconductive wafer 14 by removing the semiconductive wafer from alignment and exposure system 10 for the first time; and by subsequently processing the semiconductive wafer to develop the selectively exposed photosensitive film thereon and, for example, to simultaneously deeply etch all of those wafer alignment marks into the semiconductive wafer at the locations where they were printed.

Following the wafer alignment mark printing and forming operations in either of the foregoing cases, the first reticle 12 is removed from alignment and exposure system 10. The second reticle 12 of the set is then placed on vacuum holder 17 of stage 16 in nominal alighment with the X axis of motion of main stage 20 and is thereupon precisely aligned with the X axis of motion in exactly the same manner as previously described. This second reticle 12 is provided as shown in Figure 15, with a small wafer alignment mark 172 in the marginal portion thereof along the Y axis (once the second reticle is aligned with the X axis of motion of main stage 20) between reticle alignment mark 78b and one side of the microcircuitry-containing central portion 160 (which contains the second level of microcircuitry in the first-mentioned case and the first level of microcircuitry in the second-mentioned case). The small wafer alignment mark 172 is disposed at the same position on the second reticle 12 as a corresponding first one of the set of n-1 small wafer alignment marks 170 contained on the first reticle and is therefore illuminated with the microcircuitry-containing portion 160 of the second reticle when mask plate 60 is disposed in its operative position between positive lenses 46 and 47 and shutter 50 is opened. The small wafer alignment mark 172 may comprise a pair of square windows 173a and 173b of the same type as the reticle alignment mark 78b(i.e., a pair of light or transparent windows symmetrically oriented about the center of the wafer alignment mark on opposite sides of a pair of orthogonal centerlines thereof and disposed on a dark or opaque field), but is substantially smaller (being of about the same size as one of the small wafer alignment marks 170 contained
on the first reticle). An identical small wafer alignment
mark 172 is also provided in the same manner on each of the
succeeding reticles 12 of the set, but at the same position
as the corresponding succeeding one of the set of n-1 small
wafer alignment marks 170 contained on the first reticle.
Thus, the first through the last small wafer alignment marks
172 provided on the second through the nth reticles 12 of
the set of n reticles corresponds to the first through the
last small wafer alignment marks $170, -170_{n-1}$, respectively,
of the set of n-1 small wafer alignment marks 170 printed and
formed alongside each of the selected regions 162 of the semi-
conductive wafer 14 (the subscripts 1 through n-1 hereinafter
being used when referring specifically to the first through
the last wafer alignment marks, respectively, of a set of
n-1 small wafer alignment marks 170 formed on the semi-
conductive wafer).

The manner in which the precision alignment step-and-
repeat printing operation is performed will now be described
with reference to the parts of alignment and exposure system
10 employed in that operation. As shown in Figure 1C, a
first end of a fiber optic light pipe 174 is fixedly mounted
along a horizontally extending optical path 175 axially
aligned with the horizontally extending portion 34d of
optical path 34a-e. A second end of this fiber optic light
pipe 174 is fixedly mounted adjacent to a blue filter at
a corresponding opening in elliptical reflector 36. A beam
of blue illuminating and exposure light from mercury arc lamp
32 therefore passes through fiber optic light pipe 174
and along the horizontally extending optical path 175.

A normally closed shutter 176 pivotally mounted adjacent to the horizontally extending optical path 175 is pivoted into that optical path (as shown in solid lines) when closed so as to block passage of the beam of light therealong and is pivoted out of that optical path (as shown in dashed lines) when opened so as to permit passage of the beam of light therealong. These pivotal movements of shutter 176 are controlled by a θ servo drive unit 166 coupled thereto.

The first end of fiber optic light pipe 174, the shutter 176, the θ servo drive unit 177, and a mask plate 182 are all mounted on a stage 178 for movement therewith along the X and Z axes. Stage 178 is moved along the X and Z axes by X and Z axes servo drive units 179 and 181 to selectively position mask plate 182 in a vertical plane orthogonally intersecting the horizontally extending optical path 175 at a point midway between fiber optic light pipe 174 and a positive lens 184. Mask plate 182 has a small circular opening 186, as best shown in Figure 13, for permitting the beam of light passing along the horizontally extending optical path 175, when shutter 176 is opened, to illuminate a corresponding circular area located on the second or any succeeding reticle 12 (held by vacuum holder 17 of stage 16) and containing one (and only one) of the small wafer alignment marks 172 disposed on that reticle. Positive lens 184 is fixedly mounted in the horizontally extending optical path 175 so as to project light passing through the small circular opening 186 in mask plate 182 to the entrance pupil of imaging lens 56. Beam splitter 48 transmits twenty percent of the light passing through positive lens 184 forward along the horizontally extending portion 34d of optical path 34a-e. This light thereupon passes along the remainder of optical path 34a-e and along dual optical path 87a-f in the same manner as previously described in connection with the substage adjustment operation so that the first objective lens unit 90 may be used with binocular lens system 93, as hereinafter described, to view an aerial image of one of the small wafer alignment marks 170 on the semiconductive wafer 14, when that small wafer alignment mark is positioned directly beneath projection lens 18 and illuminated by a projected image of the corresponding small wafer alignment mark 172 disposed on the second or one of the succeeding reticles of the set.

Once the set of small wafer alignment marks 172 has been formed on the semiconductive wafer 14 alongside each of the selected regions 160 thereof, a photosensitive film is deposited over the semiconductive wafer (this is typically done at one time with the other semiconductive wafers of the batch). The semiconductive wafer 14 is then put back in alignment and exposure system 10 on vacuum chuck 17 in nominal alignment with the X axis of motion of main stage 20. It is thereupon precision prealigned with prealignment reticles 138a and 138b in exactly the same manner as previously described. In preparation for the precision alignment step-and-repeat printing operation, the X and Z axes servo drive units 179 and 181 are employed for moving stage 178 so as to position mask plate 182 for illuminating only the small wafer alignment mark 170 on the second reticle 12, when shutter 176 is subsequently opened. Additionally, slide 123 is employed to move beam bender 122 into the operative position

0111661

in the horizontally extending portion 87e of dual optical path 87a-f so that binocular lens unit 93 may be used with the first objective lens unit 90 to view an aerial image of the first small wafer alignment mark $170_1$ alongside a selected region 162 of the semiconductive wafer 14 and if the corresponding small wafer alignment mark 172 on the second reticle $12_1$ when shutter 176 is opened.

The precision alignment step-and-repeat printing operation may now be performed by employing the X and Y axes servo drive units 25 and 27 for stepping main stage 20 to position the selected region 162 in the first quadrant of the semiconductive wafer 14 directly beneath projection lens 18, thereby positioning the first small wafer alignment mark $170_1$ disposed alongside that selected region in nominal alignment with the image of the corresponding small wafer alignment mark 172 on the second reticle to be projected onto the semiconductive wafer when the shutter 176 is subsequently opened by thereupon employing the θ servo drive unit 177 for moving shutter 176 to the open position (shown in dashed lines) whereupon mask plate 182 illuminates the small wafer alignment mark 172 contained on the second reticle without illuminating either of the larger reticle alignment marks 78a and 78b or the microcircuitry-containing central portion 160 of the second reticle; by employing the first objective lens unit 90 with binocular lens unit 93 to view the aerial image of the first small wafer alignment mark $170_1$ disposed alongside the selected region 162 in the first quadrant of the semiconductive wafer and illuminated by the projected image of the corresponding wafer alignment mark 172 contained on the second reticle; while viewing that aerial image, by

-54-

employing the X and Y axes servo drive units 25 and 27 for moving the main stage so as to precisely align that first small wafer alignment mark $170_1$ in the first quadrant of the semiconductive wafer with the projected image of the corresponding small wafer alignment mark 172 on the second reticle; by measuring and storing the offset distances the main stage is moved along the X and Y axes to move the first small wafer alignment mark $170_1$ in the first quadrant of the semiconductive wafer from its initial nominally aligned position to its final precisely aligned position relative to the projected image of the corresponding small wafer alignment mark 172 on the second reticle (this may be done, for example, by simply employing the counters and the computer of the X and Y axes position control circuits disclosed in the U.S. Patent Application Serial No. 015,713 and used for controlling an interferometrically-controlled stage such as main stage 20); by employing the $\theta$ servo drive unit 177 to move shutter 176 to the closed position (shown in solid lines), thereby blocking the passage of light through mask plate 182 to the second reticle; by repeating each of the preceding steps of this paragraph in exactly the same manner for the first small wafer alignment mark $170_1$ formed alongside the selected region 162 in each of the remaining quadrants of the semiconductive wafer (i.e., for each of the small wafer alignment marks 170 formed on the semiconductive wafer and associated with the second reticle); by employing the four resultant pairs of offset distances (or values) along the X and Y axes to determine the manner in which the main stage should be moved along the X and Y axes during the following step-and-repeat printing operation to best fit those determined pairs of offset values while succesively

-55-

printing the level of microcircuitry contained on the second reticle at each of the desired array of adjacent regions 162 on the semiconductive wafer (this may be done, for example, by employing the above-mentioned computer to compute corrected coordinates (or pairs of X and Y axes end points), in accordance with well known best fit equations for X and Y axes coordinate systems, for each of the positions to which the main stage is to be stepped during the following step-and-repeat printing operation); and by then step-and-repeat printing the level of microcircuitry contained on the central portion 160 of the second reticle at each of the desired array of adjacent region 162 of the semiconductive wafer in exactly the same manner as previously described, but utilizing the corrected coordinates (or pairs of X and Y axes end points) to determine each of the positions to which the main stage is moved during that step-and-repeat printing operation (this may be done by employing the computer controlled X and Y axes position control /disclosed in the U.S. Patent Application Serial No. 015,713/ to drive the X and Y axes servo drive units 25 and 27 for the main stage).

During the foregoing precision alignment step-and-repeat printing operation, the level of microcircuitry contained on the central region 160 of the second reticle 12 is successively printed at each of the desired array of adjacent regions 162 on the semiconductive wafer 14 in very precise alignment with any level of microcircuitry previously printed and formed at those same regions of the semiconductive wafer (alignments to within one-tenth of a micron being possible). Upon completion of that precision alignment step-and-repeat printing operation, the semiconductive wafer 14 is removed from alignment and exposure system 10 and processed as previously described to form the level of microcircuitry so printed at each of the desired array of adjacent regions 162 of the semiconductive wafer. These processing operations may also impair or obliterate the first small wafer alignment mark $170_1$ disposed along side each of the selected regions 162 of the semiconductive wafer since the beam of light employed for viewing the aerial images of those first small wafer alignment marks includes exposure light as described above. However, this does not affect performance of the remaining precision alignment step-and-repeat printing operations since the remaining small wafer alignment marks $170_2 - 170_{n-1}$ formed on the semiconductive wafer and associated with the remaining reticles of the set are not illuminated until they are actually employed in performing those remaining precision alignment step-and-repeat printing operations with the associated reticles. The semiconductive wafer 14 is successively processed for each succeeding reticle 12 of the set of reticles in exactly the same manner as described above for the second reticle to successively print and form each level of microcircuitry contained on those reticles at each of the desired array of adjacent regions 162 of the semi-conductive wafer. Following all of these processing operations the semiconductive wafer may be scribed and otherwise processed as indicated above to form a plurality of integrated circuits or the like.

At some point during the previously-described processing of a semiconductive wafer 14 with alignment and exposure system 10, the operator may desire to scan the semiconductive wafer to check for possible defects (such as might occur during an etching or depositing operation) or for some other reason This may be done, without exposing a photosensitive film deposited over the semiconductive by employing air cylinder 54 to move green filter 45 into its operative position in the vertically extending portion 34c of optical path 34a-f, thereby passing only green illuminating light forward along that optical path when shutter 50 is opened; by employing crank 74 and air cylinder 75 to move compensating lens 76 into its operative position (shown in dashed lines in Figure 1A), thereby correcting projection lens 18 for green light; by employing θ servo drive unit 51 to open shutter 50; by employing the Y axis servo drive unit 66 for moving slide 58 to position mask plate 60 in its operative position, thereby permitting illumination of at least a portion of whatever object is positioned on main stage 20 directly beneath the projection lens (a reticle 12 may or may not then be held by vacuum holder 17 of stage 16); by employing slide 123 to move beam bender 122 into its operative position in the horizontally extending portion 87e of dual optical path 87a-f, thereby permitting use of the first objective lens unit 90 with the binocular lens unit 93 to view an aerial image of whatever region of the semiconductive wafer may be disposed directly beneath the projection lens and illuminated by the green light passing through the mask plate 60; and by employing the X and Y axes servo drive units 25 and 27 for moving the main stage to scan the semiconductive wafer beneath the projection lens.

Summary of the invention:

1. Photometric printing apparatus comprising:

a holder for holding a first object;

a stage for holding a second object;

a light source unit disposed for selectively illuminating different portions of the first object;

a projection lens, disposed between the holder and the stage, for projecting an image of an illuminated portion of the first object onto the second object; and

control means for moving the stage to print the image of the illuminated portion of the first object at different regions of the second object.

2. Photometric printing apparatus as in 1, including:

first optical means, disposed between the projection lens and the holder, for providing a viewing port permitting viewing of an aerial image of a portion of the second object illuminated by the projected image of the illuminated portion of the first object; and

second optical means disposed for viewing the aerial image;

said control means being operable for moving the stage to align the illuminated portion of the second object with respect to the image of the illuminated portion of the first object.

3. Photometric printing apparatus as in 1, including:

an additional stage for holding the holder; and

control means for moving the additional stage to align the first object with respect to a predetermined frame of reference.

0111661

4. Photometric printing apparatus as in , 3 wherein:

the first-mentioned stage is movable along coordinate axes; and

the predetermined frame of reference comprises at least one of the axes of motion of the first-mentioned stage.

5. Photometric printing apparatus as in 1 wherein the light source unit includes:

a light source disposed for projecting light along an optical path to the first object;

a shutter disposed for selectively controlling the passage of light along the optical path to the first object; and

a plurality of different mask plates disposed for selectively controlling the portions of the first object illuminated by light passing along the optical path to the first object when the shutter is opened.

6. Photometric printing apparatus as in 5 wherein:

the light source projects exposure light for both illuminating and exposing a photosensitive film on the second object and illumination light for illuminating without exposing the photosensitive film on the second object along the optical path; and

the apparatus includes a pair of filters disposed for selectively controlling whether exposure or illumination light passes along the optical path to the first object.

7. Photometric printing apparatus as in 1 wherein:

the holder comprises a vacuum holder for holding a first object comprising a reticle;

-60-

the stage comprises a main stage for holding a second object comprising a semiconductive wafer;

the projection lens comprises a projection lens of the reduction type;

the light source unit comprises a source of light, a shutter, and a plurality of mask plates for selectively illuminating different portions of the reticle when the shutter is opened; and

the control means is operable for moving the main stage along orthogonal X and Y axes to print the image of the illuminated portion of the reticle at different regions of the semiconductive wafer.

8. Photometric printing apparatus as in 7 including:

an optical device, disposed between the projection lens and the vacuum holder, for providing a viewing port permitting viewing of an aerial image of a portion of the semiconductive wafer illuminated by the projected image of the illuminated portion of the reticle; and

a first objective lens unit operable with a binocular lens unit for viewing the aerial image;

said control means comprising first control means for moving the main stage to align the illuminated portion of the semiconductive wafer with respect to the image of the illuminated portion of the reticle.

9. Photometric printing apparatus as in 8 including:

an additional stage for holding the vacuum holder; and

second control means for moving the additional stage along the X and Y axes and about an orthogonal Z axis to align the reticle with respect to one of the axes of motion of the main stage.

10. Photometric printing apparatus as in 9 including:

a pair of prealignment reticles aligned with respect to said one of the axes of motion of the main stage;

a light source disposed for illuminating the prealignment reticles;

a vacuum chuck, rotatably supported on the main stage, for holding the semiconductive wafer, said first control means being operable for moving the main stage along the orthogonal X and Y axes to locate the semiconductive wafer in a prealignment position beneath the prealignment reticles;

a second objective lens unit, disposed between the prealignment reticles and the main stage, for projecting images of the illuminated prealignment reticles onto the semiconductive wafer when it is located in the prealignment position, the second objective lens unit being operable with the ocular lens unit for viewing an aerial image of a pair of alignment marks disposed along opposite sides of the semiconductive wafer and illuminated by the projected images of the prealignment reticles; and

third control means operable with the first control means for rotating the vacuum chuck and moving the main stage to align the illuminated alignment marks on the semiconductive wafer with the projected images of the prealignment reticles.

1. Alignment apparatus comprising:

a holder for holding a first object;

a stage for holding a second object, said stage being movable along coordinate axes to position the second object with respect to the first object; and

means for aligning an indicuim with one of the axes of motion of the stage.

2. Alignment apparatus as in claim 1 wherein said means comprises a substage mounted on the stage and provided with adjustment means for positioning the indicuim in a plane parallel to a plane of the stage and for positioning the indicuim in alignment with said one of the axes of motion of the stage.

3. Alignment apparatus as in claim 2 including:

control means for moving the holder to position the first object with respect to the indicuim; and

optical means for viewing the indicuim and the first object.

4. Alignment apparatus as in claim 3 wherein:

said indicuim comprises a reference mark disposed on the substage and visible through the optical means; and

said adjustment means comprises a first adjustment screw for adjusting the substage to position the reference mark in a plane parallel to an image plane of the optical means and a second adjustment screw for adjusting the substage to position the reference mark in alignment with said one of the axes of motion of the stage.

**Dr.-Ing. Roland Liesegang**

Patentanwalt
European Patent Attorney

Sckellstrasse 1
D-8000 München 80
Telefon (089) 4 48 24 96

Telex 5214382 pali d
Telekopierer (089) 2720480, 2720481
Telegramme patemus münchen

Postscheck München 39418-802
Hypobank München 6400194333
Reuschelbank München 2603007

0111661

– 64 –

OPTIMETRIX CORPORATION

Mountain View, USA

EU 140 34

divisional from 80 101 307.9

Claims

Photometric printing apparatus

1. Photometric printing apparatus including a holder (16) for holding a first object (12) in a first plane; a stage (20) for holding a second object (14) in a second plane (77); a light source unit (24), optically disposed on one side of the holder (16), for illuminating the first object (12); a projection lens (18), optically disposed on the other side of the holder (16) and between the holder (16) and the stage (20), for projecting an image of illuminated portions of the first object (12) onto the second object (14); and control means (25,27), coupled to the stage (20), for moving the stage (20) to facilitate printing of an image of an illuminated portion (160) of the first object (12) at different regions (162) of the second object (14); c h a r a c t e r i z e d   by an indicium (26) disposed on the stage (20) for being positioned in the second plane (77) to facilitate alignment of the image of the first object (12) with respect to one of the axes (X,Y) of motion of the stage (20).

2. Apparatus as in claim 1, c h a r a c t e r i z e d by adjustable mounting means (30) for mounting the indicium (26) on the stage (20) in the second plane (77) to facilitate positioning the indicium (26) in alignment with respect to said one of the axes (X,Y) of motion of the stage (20).

3. Apparatus as in claim 2, c h a r a c t e r i z e d in that said adjustable mounting means (30) may also be employed to facilitate positioning the indicium (26) in a plane parallel to and coincident with the second plane (77).

4. Apparatus as in claim 3, c h a r a c t e r i z e d in that said adjustable mounting means (30) comprises a substage (30) mounted on the stage (20), said substage (30) being provided with a first adjustment screw (206) for adjusting the substage (30) to position the indicium (26) in a plane parallel to and coincident with the second plane (77) and being further provided with a second adjustment screw (214) for adjusting the substage (30) to position the indicium (26) in alignment with respect to said one of the axes (X,Y) of motion of the stage (20).

5. Apparatus as in any of the preceding claims, c h a r a c t e r i z e d in that the first object (12) is a reticle (12) and the second object (14) is a semiconductive wafer (14).

FIGURE 1A

Serial No. 26,722
Grcup No. 337

0111661

FIGURE 1B

FIGURE 1C

FIGURE 2

**FIGURE 3A**

26
26a
26b
26b
28

**FIGURE 3B**

204
260  28  26  210
212
30
202
202  206  208  214  200
20

**FIGURE 3C**

206  204
214
205
208
30
200
20

FIGURE 4

FIGURE 5

FIGURE 6

FIGURE 7

FIGURE 8

FIGURE 9A

FIGURE 9B

FIGURE 10A

FIGURE 10B

FIGURE 10C

FIGURE 12

FIGURE 11

10/12

FIGURE 13

12

130A

78A

170

170₁

170₂

130B

78B

170ₙ₋₁

160

FIGURE 14

12/12

FIGURE 15